# EUROPEAN PATENT APPLICATION

(11) **EP 2 978 134 A1**
(43) Date of publication of application: **27.01.2016**
(21) Application number: 13878620.7
(22) Date of filing: 22.03.2013
(51) Int. Cl.: H03M 7/40

(54) **COMPRESSION DEVICE, COMPRESSION METHOD, DICTIONARY GENERATION DEVICE, DICTIONARY GENERATION METHOD, EXPANSION DEVICE, EXPANSION METHOD, EXPANSION PROGRAM, AND INFORMATION PROCESSING SYSTEM**

(71) Applicant: Fujitsu Limited, Kawasaki-shi, Kanagawa 211-8588 (JP)
(72) Inventor: MURAMATSU, Chiori, Kawasaki-shi Kanagawa 211-8588 (JP); NISHIZAWA, Shinichiro, Kawasaki-shi Kanagawa 211-8588 (JP); KATAOKA, Masahiro, Kawasaki-shi Kanagawa 211-8588 (JP); IDEUCHI, Masao, Kawasaki-shi Kanagawa 211-8588 (JP)
(74) Representative: Hoffmann Eitle
(86) International application number: PCT/JP2013/001977
(87) International publication number: WO 2014/147672

(57) **Abstract**

An object of one aspect of the present invention is to prevent a reduction in compression ratio due to the existence of orthographic variants.

According to one aspect, a compression device includes a storage unit that stores therein dictionary information in which a first compressed code assigned to a plurality of pieces of character information different from one another is associated with the pieces of character information; an acquiring unit that, when a first piece of character information among the pieces of character information is acquired, acquires the first compressed code associated with the first piece of character information from the dictionary information; and a writing unit that writes the acquired first compressed code in a storage area to store compressed data.

## Description

### [Technical Field]

The present invention relates to at least one of a compression technology and a decompression technology of data.

### [Background Art]

In compression algorithms that use variable length compressed codes such as Huffman coding and arithmetic compression, a compressed code having the length according to the statistical information such as appearance frequency is assigned to each piece of character information included in a character information group, relative to the character information group, to which compressed codes are assigned. In the Huffman coding compression algorithm, compressed codes are generated by comparing the appearance frequencies of pieces of character information included in the character information group. In the arithmetic compression, compressed codes having a predetermined code length are generated, based on the appearance ratio of each piece of the character information in the whole character information group. In the compression algorithms such as these, short compressed codes are assigned to pieces of character information with high appearance frequency. Because short compressed codes are used more frequently, the compression ratio of the entire compressed data is improved.

Objects to which variable length compressed codes are assigned in the compression algorithm such as Huffman coding and arithmetic compression are symbols such as characters and numbers. There is a known technology in which the object to which the compressed codes are assigned is expanded, and a variable length compressed code is assigned to a character string such as a word or a tag, which is a combination of symbols. In this case, because one compressed code is assigned to a combination of a plurality of symbols, the compression ratio is improved (see Patent Document 1, for example).

### [Citation List]

### [Patent Citation]

Patent Document 1: Japanese Laid-open Patent Publication No. 2010-93414
Patent Document 2: Japanese Laid-open Patent Publication No. 05-241777

### [Summary of Invention]

### [Technical Problem]

Document data is made up of character strings, such as words and tags, which are combinations of symbols such as characters and numbers. Each character string in the document data corresponds to a concept that has a specific meaning, a grammatical function, or the like. However, even if the character strings correspond to a common concept, some of them have different combinations of symbols (notations) from one another. In other words, what is called orthographic variants exist. Examples of the orthographic variants are inflected forms of verbs and adjectives, and synonyms and near-synonyms.

When variable length compressed codes are assigned to character strings such as words or tags, short compressed codes are assigned to pieces of character information that appear more frequently. However, if there are orthographic variants, a plurality of character strings (multiple types of character strings) that are written differently from one another correspond to one concept. Accordingly, the appearance frequency of each of the multiple types of character strings becomes less, compared to that when there is no orthographic variants and only one type of character string corresponds to one concept. As a result, a long compressed codes is assigned to each of the multiple types of character strings, thereby causing a reduction in the compression ratio.

An object of one aspect of the present invention is to prevent a reduction in compression ratio due to the existence of orthographic variants.

### [Solution to Problem]

In one aspect, a compression device comprises: a storage unit configured to store therein dictionary information in which a first compressed code assigned to a plurality of pieces of character information different from one another is associated with the pieces of character information; an acquiring unit configured to, when a first piece of character information among the pieces of character information is acquired, acquire the first compressed code associated with the first piece of character information from the dictionary information; and a writing unit configured to write the acquired first compressed code in a storage area to store compressed data.

In one aspect, a decompression device comprises: a storage unit configured to store therein dictionary information in which a first compressed code assigned in common to a plurality of pieces of character information different from one another is associated with a first piece of character information corresponding to the pieces of character information; an acquiring unit configured to, when the first compressed code is acquired from compressed data, acquire the first piece of character information associated with the first compressed code in the dictionary information, from the dictionary information; and a writing unit configured to write the acquired first piece of character information in a storage area to store a decompression result of the compressed data.

In one aspect, an information processing system comprises: a storage device configured to store therein compressed data; and a processing device configured to execute processing according to a processing request on the compressed data, and the processing device comprises: a storage unit configured to store therein dictionary information in which a first compressed code assigned to a plurality of pieces of character information different from one another is associated with the pieces of character information; a reading unit configured to read out the compressed data from the storage device according to the processing request; a first acquiring unit configured to, when the first compressed code is acquired from the compressed data, acquire first character information associated with the first compressed code in the dictionary information, from the dictionary information; a first writing unit configured to write the acquired first character information in a first storage area to store a decompression result of the compressed data; a processing unit configured to execute the processing according to the processing request on the decompression result stored in the first storage area; a second acquiring unit configured to, when the first character information is acquired from data on which the processing according to the processing request is performed, acquire the first compressed code associated with the first character information in the dictionary information; a second writing unit configured to write the acquired first compressed code in a second storage area; and a storage unit configured to store, in the storage device, data written in the second area.

In one aspect, a dictionary generation device comprises: an assignment unit configured to assign a compressed code to one type of common character information corresponding to a plurality of pieces of character information different from one another; and a generation unit configured to generate dictionary information in which a first compressed code assigned to the common character information is associated with the individual pieces of character information.

In one aspect, a dictionary generation device comprises: a generation unit configured to generate dictionary information in which a first compressed code assigned in common to a plurality of pieces of character information different from one another is associated with a first piece of character information corresponding to the pieces of character information.

### [Advantageous Effects of Invention]

According to an aspect of the present invention, it is possible to prevent a reduction in compression ratio due to the existence of orthographic variants.

### [Brief Description of Drawings]

FIG. 1 is an overview of compression processing and decompression processing.
FIG. 2 is an example of conversion to compressed codes.
FIG. 3 is a configuration example of functional blocks.
FIG. 4 is an example of a processing procedure of a compression function.
FIG. 5 is an example of a processing procedure of generating a compression dictionary.
FIG. 6 is an example of a processing procedure for counting the appearance frequency.
FIG. 7 is an example of a conversion table T1.
FIG. 8 is an example of a statistical table T2.
FIG. 9 is an example of a data structure of a compression dictionary D1.
FIG. 10 is an example of a processing procedure for generating compressed data.
FIG. 11 is an example of a processing procedure of a decompression function.
FIG. 12 is an example of a processing procedure for generating a decompression dictionary.
FIG. 13 is an example of a data structure of a decompression dictionary D2.
FIG. 14 is an example of a processing procedure for generating decompressed data.
FIG. 15 is an example of conversion to compressed codes.
FIG. 16 is an example of a data structure of a compression dictionary.
FIG. 17 is an example of a data structure of a decompression dictionary.
FIG. 18 is an example of a processing procedure for generating decompressed data.
FIG. 19 is an example of an assignment of compressed codes.
FIG. 20 is an example of a data structure of a decompression dictionary.
FIG. 21 is an example of a processing procedure for generating decompressed data.
FIG. 22 is an example of a processing procedure for generating decompressed data.
FIG. 23 is an example of a processing procedure for generating decompressed data.
FIG. 24 is an example of a processing procedure for generating decompressed data.
FIG. 25 is an example of a processing procedure for generating decompressed data.
FIG. 26 is an example of a processing procedure for generating decompressed data.
FIG. 27 is an example of a processing procedure for generating decompressed data.
FIG. 28 is a configuration example of hardware in a computer 1.
FIG. 29 is a configuration example of computer programs to be operated in the computer 1.
FIG. 30 is a configuration example of a system using the computer 1.
FIG. 31 is a configuration example of a system using the computer 1.

### [Embodiments for Carrying Out the Invention]

### [Flows of Compression Processing and Decompression Processing]

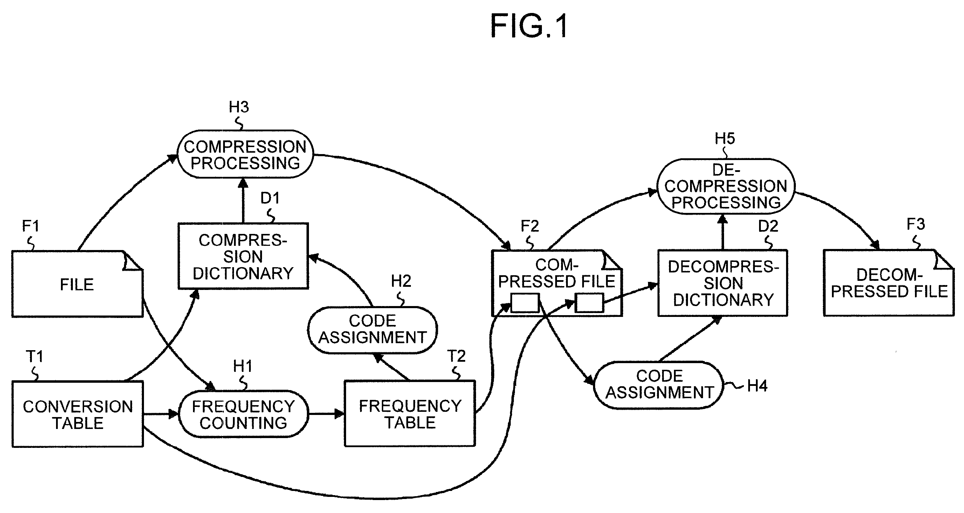

FIG. 1 is an overview of compression processing and decompression processing. A compressed file F2 is generated based on a file F1 and a conversion table T1. In the conversion table T1, multiple types of character information corresponding to a common concept are each mapped to common character information that indicates the concept common to the multiple types of character information. For example, in the conversion table T1, identifying symbols to discriminate the multiple types of character information from one another may also be mapped to the respective multiple types of character information (a plurality of pieces of character information different from one another) described above.

Frequency counting H1 in the file F1 is performed on each of the character information groups, to which a compressed code is assigned based on the conversion table T1. In the process of the frequency counting H1, the character information mapped to the common character information in the conversion table T1 is counted as common character information. In the process of the frequency counting H1, the character information mapped to the identifying symbol may be counted both as the common character information and the identifying symbol. The results of the frequency counting H1 are stored in a frequency table T2.

For example, the process of the frequency counting H1 may be performed based on a file (such as a book having a different version number) that is likely to include a number of pieces of character information common to the file F1, instead of the file F1. The frequency counting H1, for example, may also be performed based on a plurality of files (a divided file group obtained by dividing a certain file (including file F1)) including the file F1.

A code assignment H2 is performed on the character information group (including common character information or including both of common character information and identifying symbol) stored in the frequency table T2, based on the corresponding appearance frequency. For example, according to the Huffman coding algorithm, a compressed code is assigned to each piece of character information, by comparing the appearance frequencies of the pieces of character information. For example, according to the arithmetic compression, a code length is set according to the appearance ratio of each piece of the character information in the whole character information group, to which a compressed code is assigned. Consequently, a compressed code having the set code length is assigned to each piece of the character information. A compression dictionary D1 indicates corresponding relations between the character information groups (including common character information or including both of common character information and identifying symbol) and the respective assigned compressed codes. In compression processing H3, a compressed code corresponding to the character information included in the file F1 is sequentially obtained from the compression dictionary D1. The compressed file F2 includes compressed code strings (compressed data) of the sequentially obtained compressed codes, the conversion table T1, and the frequency table T2.

In the process of the frequency counting H1 described above, the multiple types of character information corresponding to the common concept are integrated in the common character information. Accordingly, in the code assignment H2, the types of character information to which the compressed codes are assigned are reduced. Consequently, it is possible to prevent a reduction in the appearance frequency due to orthographic variants. Because the code length of the compressed codes assigned to the character information is kept short, it is possible to prevent a reduction in the compression ratio due to orthographic variants. Because the types of character information to which the compressed codes are assigned are decreased, the processing amount of the code assignment H2 is reduced. Because the compressed codes are assigned to all of the multiple types of character information, it is also possible to prevent an unexpected reduction in the compression ratio, caused by not assigning a compressed code to character information.

The information on the appearance frequency of the common character information stored in the frequency table T2 can be directly used for text mining. Even without decompressing the compressed data, it is possible to extract information, such as what kind of concept is indicated in what sort of frequency in the document data, from the frequency table T2.

A decompressed file F3 is generated based on the compressed file F2. As described above, the compressed file F2 includes the compressed data, the conversion table T1, and the frequency table T2. A code assignment H4 is performed on the character information group (including common character information or including both of common character information and identifying symbol) stored in the frequency table T2 retrieved from the compressed file F2, based on the appearance frequency mapped in the frequency table T2. The process of the code assignment H4 is performed based on the same algorithm as that in the process of the code assignment H2. A decompression dictionary D2 indicates the corresponding relation between a compressed code and the character information to which the compressed code is assigned. In decompression processing H5, the character information corresponding to the compressed code retrieved from the compressed file F2 is obtained from the decompression dictionary D2. In the decompression processing H5, when the compressed code corresponding to the common character information is obtained from the compressed file F2, the common character information corresponding to the compressed code is obtained from the decompression dictionary D2. When the compressed code mapped to the identifying symbol is used, the decompression dictionary D2 includes the storage position (offset value) of the common character information in the conversion table T1 retrieved from the compressed file F2, instead of the common character information. When the offset value is obtained from the decompression dictionary D2 in the decompression processing H5, the original character information is obtained based on the offset value and the identifying symbol. The decompressed file F3 includes the character information strings of the character information obtained by the decompression processing H5.

In the frequency table T2 included in the compressed file F2, the multiple types of character information corresponding to the common concept are integrated in the common character information. Accordingly, in the code assignment H4, the types of character information to which the compressed codes are assigned are reduced.

If the file F1 and the decompressed file F3 are the same data, the compression processing H3 and the decompression processing H5 are reversible compression and decompression processes. If the file F1 and the decompressed file F3 are not the same data, the compression processing H3 and the decompression processing H5 are irreversible compression and decompression processes. In other words, when the multiple types of character information corresponding to the common concept are identified by the identifying symbol in the conversion table T1, reversible compression and decompression processes are performed, because the character information before being compressed can be specified in the conversion table T1 during decompression, based on the identifying symbol.

### [Orthographic Variants and Appearance Frequency of Character Information]

As an example of orthographical variants, document data may include synonyms. For example, there are words that are written differently in British English and American English (such as "pavement" and "sidewalk"). There are also some words that are acknowledged to have a plurality of spellings (such as "center" and "centre"). In Japanese, for example, some foreign words are allowed to be written in a plurality of ways when they are translated (such as "interface" that can be expressed in two ways in Japanese). In each language, there are near-synonyms (such as "center" and "middle") similar to synonyms. Because these synonyms and near-synonyms have common concepts, they can be integrated in common character information. By doing so, it is possible to prevent the reduction in appearance frequency due to orthographic variants. Because the code length of the compressed codes assigned to the pieces of character information is kept short, it is possible to prevent the reduction in the compression ratio due to orthographic variants. Because the pieces of character information to which the compressed codes are assigned are integrated in the common character information, the processing amount of assigning the variable length compressed codes is reduced. It is also possible to prevent an unexpected reduction in the compression ratio, caused by not assigning a compressed code to a character string.

In a language such as English, the first letter of the first word in a sentence is written in a capital letter. When compressed codes are only assigned to the words whose first letter is written in a small letter, the first words of sentences in the document data are not replaced with the compressed codes. This does not contribute to the improvement of compression ratio. When a compressed code is individually assigned to both of the word whose first letter is a capital letter and the word whose first letter is a small letter, the number of types of character information to which the compressed codes are assigned is doubled. Accordingly, the processing amount of assigning the compressed codes is increased. In such orthographic variants, when the common character information corresponding to both of the word whose first letter is a capital letter and the word whose first letter is a small letter is used, and also the identifying symbol to indicate whether the first letter is a capital letter or a small letter is used, it is possible to prevent a reduction in the compression ratio. It is also possible to prevent an increase in the processing amount of assigning the compressed codes.

There are also inflections in particular languages (such as English, German, and Japanese). An inflected word is a word whose form changes according to the grammatical constraints. In English, for example, verbs, adjectives, and adverbs have inflections. In document data written in the language that has inflections, some words are written in different character strings due to inflections according to the grammatical constraints. For example, in English, each verb has five inflections of base form, third person singular present tense, past tense, past participle, and present participle. Although they correspond to a common concept, they are written differently. Accordingly, for example, when compression processing is performed by integrating the words expressed by inflections in the common character information corresponding to the concept (such as the base form of verb) of the inflected words, it is possible to prevent the reduction in the compression ratio. It is also possible to prevent the increase in the processing amount of assigning the compressed codes. By using the identifying symbol to indicate an inflected form (such as indicating past tense) at the same time, it is also possible to return the word to its original inflected form during decompression.

The appearance frequency of character information varies by document data. Accordingly, the appearance frequency varies by each piece of character information. However, unlike the synonyms and near-synonyms, or the orthographic variants of the first letter of the first word in a sentence, in the inflections, the appearance frequencies of the multiple types of character information corresponding to the common concept tend to be similar. The pieces of character information of inflected words formed differently from one another are sometimes simultaneously used in a document. For example, a sentence including "the searched data is ..." or the like may follow a sentence including "search data for ..." or the like. Because the appearance frequencies of the pieces of character information integrated in the common character information tend to be similar, the compressed code that does not match the appearance frequency of each piece of the character information is less likely to be assigned.

Moreover, there are common trends in all verbs. For example, the base form and the past tense of verbs appear frequently but the past participle appears less frequently. If compressed codes are assigned to identifying symbols indicating inflected forms based on the appearance frequency, a short compressed code is assigned to the inflected form with high appearance frequency, and a long compressed code is assigned to the inflected form with low appearance frequency. Even if the appearance frequencies differ by the words with different inflections, the code length is adjusted by the compressed code assigned to the identifying symbol.

When the identifying symbol indicating an inflected form is not used, it will be irreversible compression. However, the compressed data obtained by irreversible compression is utilized for text mining and the like. When the irreversible compressed data is decompressed, the information on the inflected forms of verbs will be lost. On the other hand, an analysis on usage frequency of verbs such as "like" and "hate", and the extraction of a keyword that co-occurs with the verbs can be executed based on the irreversible compressed data.

### [Conversion to Compression Codes]

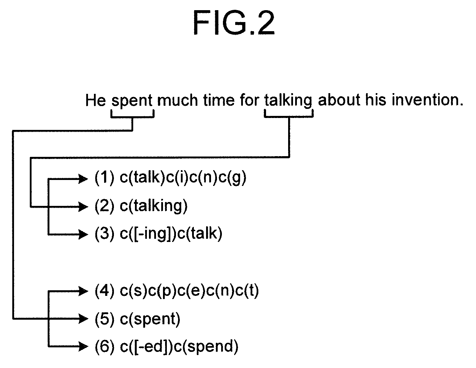

FIG. 2 is an example of conversion to compressed codes. FIG. 1 is provided with an English sentence "He spent much time for talking about his invention". Examples (1) to (6) in FIG. 2 illustrate when a part of the English sentence provided in FIG. 1 is converted by using the compressed codes assigned to the character information such as a word and a character. Examples (1) to (3) illustrate exemplary compressed codes corresponding to the character information of "talking". Examples (4) to (6) illustrate exemplary compressed codes corresponding to the character information of "spent". Both "talking" and "spent" are inflected forms of verbs.

As an example of a method to assign compressed codes to a word, there is a method of assigning a compressed code only to the base form of verbs. For example, a compressed code c(talk) and a compressed code c(spend) are assigned to the verbs "talk" and "spend", respectively. Hereinafter, the compressed code is indicated as "c()". When the compressed code is indicated as "c()", the character information corresponding to the compressed code is indicated in the round parentheses. In such a case, in "talking", the compressed code is only assigned to the base form of "talk". Accordingly, for example, "ing" is expressed by combining a compressed code c(i), a compressed code c(n), and a compressed code c(g). Consequently, as illustrated in example (1), "talking" is converted into a compressed code string of c(talk)c(i)c(n)c(g). Because "spent" is not a character string including "spend" to which the compressed code is assigned, the compressed code c(spend) is not used. As a result, for example, as illustrated in example (4), "spent" is converted into a compressed code string of c(s)c(p)c(e)c(n)c(t).

The inflected forms of the same verb such as "talk", "talked", and "talking" belong to a character information group in which they are written differently due to grammatical constraints, although they have the common meaning. Even if a compressed code is assigned to one in the character information group, when the other pieces of character information are converted into compressed codes, a compressed code is assigned per character for a part or the whole word. Consequently, the character information per word is converted into a plurality of compressed codes, and this may prevent the improvement of the compression ratio.

As a method of assigning compressed codes to a word, there is a method of assigning a compressed code to each inflected form of a verb. For example, for a verb "talk", compressed codes of c(talk), c(talking), and (talked) are mapped to "talk", "talking", and "talked", respectively. For a verb "spend", for example, compressed codes of c(spend), c(spending), and (spent) are mapped to "spend", "spending", and "spent", respectively. In this case, "talking" in the English sentence illustrated in FIG. 2, as illustrated in example (2), is converted into a compressed code c(talking). Also, "spent" in the English sentence, as illustrated in example (5), is also converted into a compressed code c(spent).

According to examples (2) and (5), although the meaning of each verb itself is the same, compressed codes corresponding to the respective five inflected forms (base form, third person singular present tense, past tense, past participle, and present participle) exist due to inflection. Accordingly, the types of compressed codes are increased. If the types of compressed codes are increased, the sizes of the compression dictionary and the decompression dictionary are also increased. It also increases the processing amount of generating compressed codes to be assigned to each character string. When the types of compressed codes are increased, the compression speed and the decompression speed slow down. The processing amount of assigning compressed codes, and the relation between the compression dictionary data structure and the number of types of compressed codes will be described in detail below.

As one of the methods of assigning compressed codes, there is a method of converting all of the multiple types of character information that have the common meaning into a compressed code assigned to the common character information that indicates the meaning common to the multiple types of character information. For example, "talk", "talking", and "talked" are converted into a compressed code c(talk) assigned to "talk" indicating the common meaning. Similarly, for example, character information such as "spent" is converted into a compressed code c(spend). When the character information is compressed by using a compressed code assigned to the common character information, the decompressed data obtained by decompressing the compressed data depicts the meaning common to the multiple types of character information described above. On the other hand, because the common compressed code is assigned, the decompressed data is written in the same way. When the compressed code assigned to the common character information is used, only the common meaning is reproduced when the compressed data is decompressed. Accordingly, the method described above is used as irreversible compression.

In addition to the above-described irreversible compression, for example, identifying symbols to discriminate from one another the multiple pieces of character information that have the common meaning are used. For example, identifying symbols such as "-ing" and "-ed" are used to identify the pieces of character information such as "talking" and "talked" that have the common meaning of "talk". Hereinafter, identifying symbols are indicated in the square parentheses. For example, an identifying symbol "-ing" has a grammatical function indicating that the word is in the present progressive form. For example, an identifying symbol "-ed" has a grammatical function indicating that the word is in the past tense.

For example, as illustrated in example (3), by using both of the compressed code c(talk) and the compressed code c([-ing]), compressed data corresponding to the character information "talking" is generated. When this compressed data is decompressed, it is possible to judge that the present progressive form of the character information "talk" is in the decompressed data. Consequently, the character information "talking" is reproduced. For example, as illustrated in example (6), by using both of the compressed code c(spend) and the compressed code c([-ed]), compressed data corresponding to the character information "spent" is generated. When this compressed data is decompressed, it is possible to judge that the past tense of the character information "spent" is in the decompressed data. Consequently, the character information "spent" is reproduced. By combining the compressed code assigned to the common character information and the compressed code assigned to the identifying symbol, the character information can be reproduced. Consequently, it is used as reversible compression.

According to the compression method illustrated by using example (3) and example (6), any word whose notations have changed due to grammatical constraints can be expressed with two compressed codes. Consequently, it is possible to prevent an increase in the types of compressed codes, which occurs in example (1) and example (4), when the words, to which compressed codes are assigned, correspond to the same concept but are written differently. The identifying symbol may be used in common for multiple types of verbs. As a result, the types of compressed codes are increased as many as the number of pieces of character information corresponding to the common concept. However, for example, if compressed codes are assigned to 800 types of verbs, as in example (2) and example (5), the types of compressed codes are significantly increased to several times of 800 types. On the other hand, for example, when the grammatical functions of five types of verbs of base form, third person singular present tense, past tense, past participle, and present participle are to be identified, only five types of compressed codes are assigned to a verb. By assigning the compressed codes as illustrated in example (3) and example (6), it is possible to prevent the situations as described in example (1) and example (4), with hardly increasing the types of compressed codes.

### [Structures and Procedures of the Present Embodiment]

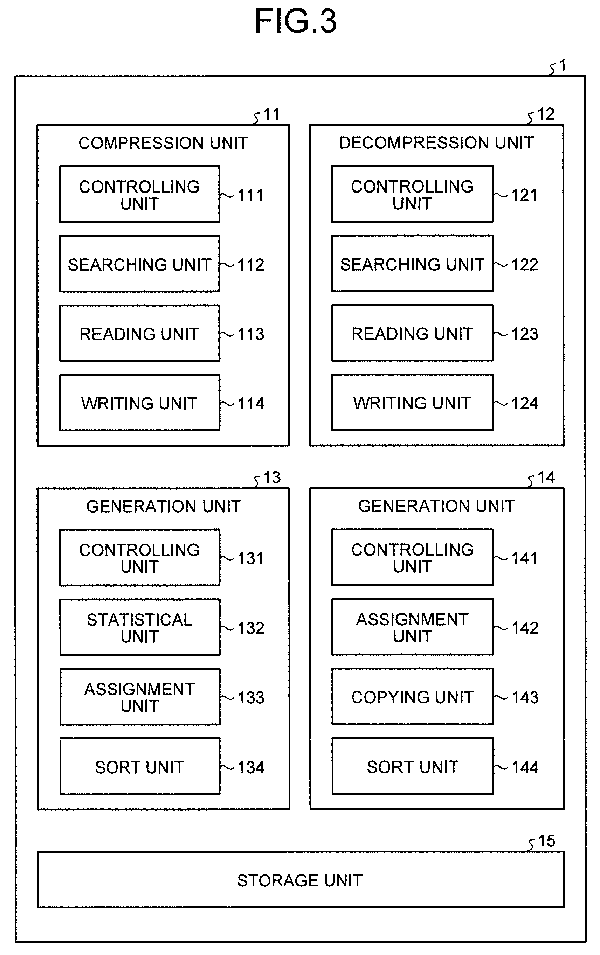

FIG. 3 is a configuration example of functional blocks. A computer 1 includes a compression unit 11, a decompression unit 12, a generation unit 13, a generation unit 14, and a storage unit 15. The storage unit 15, for example, stores therein the file F1 to be compressed, the compressed file F2, the decompressed file F3, the compression dictionary D1, and the decompression dictionary D2. The storage unit 15, for example, also stores therein a word list L1 used to generate the compression dictionary D1 and the decompression dictionary D1. The word list L1 is a list of character information groups to which compressed codes are assigned. The storage unit 15 also stores therein the conversion table T1. The storage unit 15 provides storage areas such as storage areas A1, A2, A3, and A4, which are used as work areas by the compression unit 11, the decompression unit 12, the generation unit 13, and the generation unit 14. The compression unit 11 executes compression processing of the file F1 stored in the storage unit 15, and generates the compressed file F2. The decompression unit 12 executes decompression processing of the compressed file F2 stored in the storage unit 15, and generates the decompressed file F3. The generation unit 13 generates the compression dictionary D1 used by the compression unit 11 for compression processing. The generation unit 14 generates the decompression dictionary D2 used by the decompression unit 12 for decompression processing.

The compression unit 11 includes a controlling unit 111, a searching unit 112, a reading unit 113, and a writing unit 114. The controlling unit 111 executes compression processing of the file F1, by controlling the searching unit 112, the reading unit 113, and the writing unit 114. The controlling unit 111 loads the file F1 in the storage area A1. The reading unit 113 reads out data from the file F1 in the storage area A1. The searching unit 112 searches the compression dictionary D1 for the data read out by the reading unit 113. The writing unit 114 writes the compressed codes according to the searching results of the searching unit 112 in the storage area A2. The controlling unit 111 manages the reading position of the reading unit 113 and the writing position of the writing unit 114. For example, the controlling unit 111 causes the reading unit 113 and the writing unit 114 to sequentially process the character code strings in the file F1. The controlling unit 111 also generates the compressed file F2 based on the compressed data stored in the storage area A2, and stores the compressed file F2 in the storage unit 15.

The decompression unit 12 includes a controlling unit 121, a searching unit 122, a reading unit 123, and a writing unit 124. The controlling unit 121 executes decompression processing of the compressed file F2, by controlling the searching unit 122, the reading unit 123, and the writing unit 124. The controlling unit 121 loads the compressed file F2 in the storage area A3. The reading unit 123 reads out the compressed codes from the compressed file F2 in the storage area A3. The searching unit 122 searches the compressed code read out by the reading unit 123 in the decompression dictionary D2. The searching unit 122 then determines whether the decompression code obtained from the decompression dictionary D2 is the character information or an offset value in the conversion table T1. If it is the offset value, the searching unit 122 obtains the character information based on the offset value. The writing unit 124 writes the character information obtained by the searching unit 122 in the storage area A4. The controlling unit 121 manages the reading position of the reading unit 123 and the writing position of the writing unit 124, and for example, causes the reading unit 123 and the writing unit 124 to sequentially process the compressed codes included in the compressed file F2. The controlling unit 121 also generates the decompressed file F3 based on the character information strings (decompressed data) stored in the storage area A4, and stores the decompressed file F3 in the storage unit 15.

The generation unit 13 includes a controlling unit 131, a statistical unit 132, an assignment unit 133, and a sort unit 134. The generation unit 13 generates the compression dictionary D1 according to an instruction from the compression unit 11. The controlling unit 131 generates the compression dictionary D1 used to compress the file F1, by controlling the statistical unit 132, the assignment unit 133, and the sort unit 134. The statistical unit 132 counts the appearance times of each piece of the character information of characters and words included in the file F1, and generates the frequency table T2 that indicates the appearance frequency of each piece of the character information. The sort unit 134 sorts each piece of character information in the frequency table T2, based on the appearance frequency generated by the statistical unit 132. The assignment unit 133 generates a compressed code corresponding to each piece of the character information based on the appearance frequency generated by the statistical unit 132, and assigns the generated compressed code to each piece of the character information. The sort unit 134 also sorts each set of a combination of character information and a compressed code, in a sequence of character codes corresponding to respective pieces of character information (for example, in ascending order of the character code values). The controlling unit 131 generates the compression dictionary D1 based on the processing results of the statistical unit 132, the assignment unit 133, and the sort unit 134, and stores the compression dictionary D1 in the storage unit 15. The controlling unit 131 then stores the frequency table T2 generated by the statistical unit 132 in the storage unit 15.

The generation unit 14 includes a controlling unit 141, an assignment unit 142, a copying unit 143, and a sort unit 144. The generation unit 14 generates the decompression dictionary D2 according to an instruction from the decompression unit 12. The controlling unit 141 controls the assignment unit 142, the copying unit 143, and the sort unit 144, and generates the decompression dictionary D2 used for decompressing the compressed file F2. The assignment unit 142 generates a compressed code corresponding to each piece of the character information in the frequency table T2, by using the frequency table T2. The sort unit 144 sorts each piece of the character information to which the compressed code is assigned, according to the value of the compressed code. The copying unit 143 copies the character code indicating a character or a word corresponding to the compressed code, according to the code length of each compressed code that has been sorted. The controlling unit 141 generates the decompression dictionary D2, by arranging the character code copied by the copying unit 143 to the offset position corresponding to the compressed code generated by the assignment unit 142. The controlling unit 141 then stores the decompression dictionary D2 in the storage unit 15.

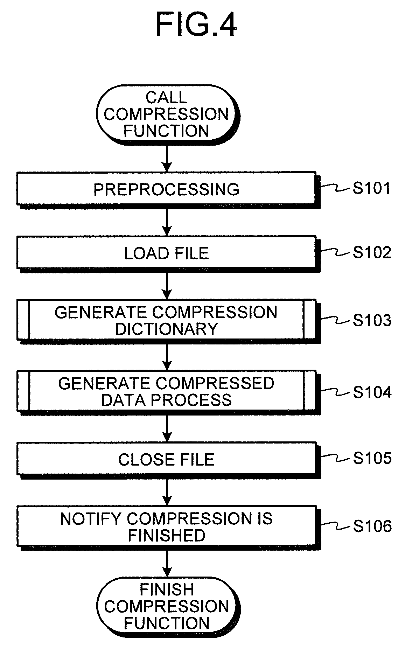

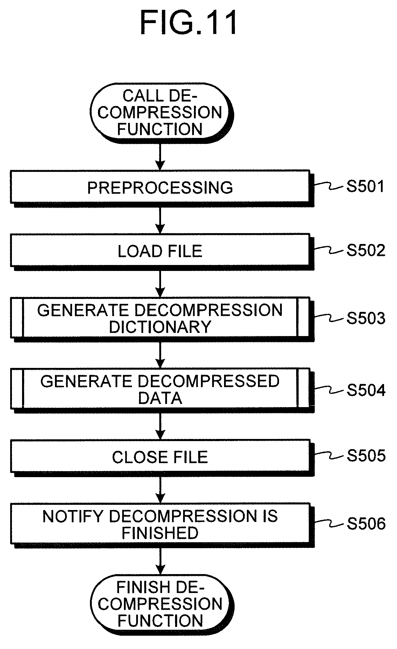

The compression unit 11 and the generation unit 13 compress the file F1. The compression procedures are illustrated in FIG. 4, FIG. 5, FIG. 6, and FIG. 10. The decompression unit 12 and the generation unit 14 decompress the compressed file F2. The decompression procedures are illustrated in FIG. 11, FIG. 12, and FIG. 14.

FIG. 4 is an example of a processing procedure of a compression function. When the compression function is called, the controlling unit 111 executes preprocessing of the compression processing (S101). The calling of the compression function includes a specification of the file F1 to be compressed. In the preprocessing at S101, the controlling unit 111 secures the storage area A1 and the storage area A2, loads the word list L1 and the conversion table T1 from the storage unit 15, and secures the storage area for the frequency table T2 and the compression dictionary D1.

When the processing at S101 is finished, the controlling unit 111 loads the file F1 in the storage area A1 (S102). If the size of the file F1 is larger than a predetermined size, the controlling unit 111 divides the file F1 into blocks, and performs the following compression processing on each block obtained by the division. The controlling unit 111 then instructs the generation unit 13 to generate the compression dictionary D1 (S103).

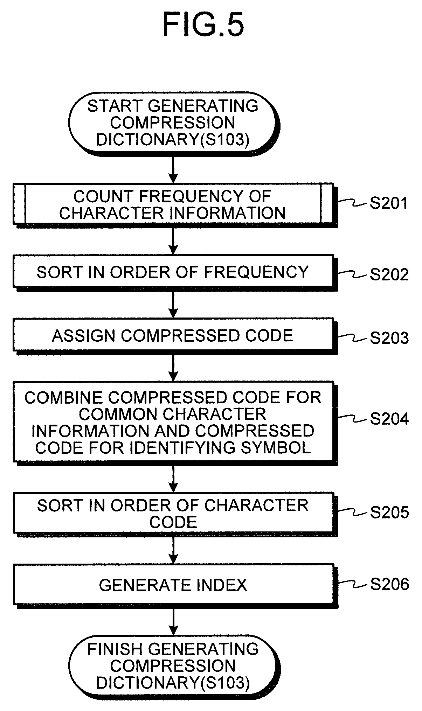

FIG. 5 is an example of a processing procedure for generating a compression dictionary. On receiving an instruction to generate the compression dictionary from the controlling unit 111, the controlling unit 131 causes the statistical unit 132 to count the appearance frequency of the character information included in the file F1 (S201).

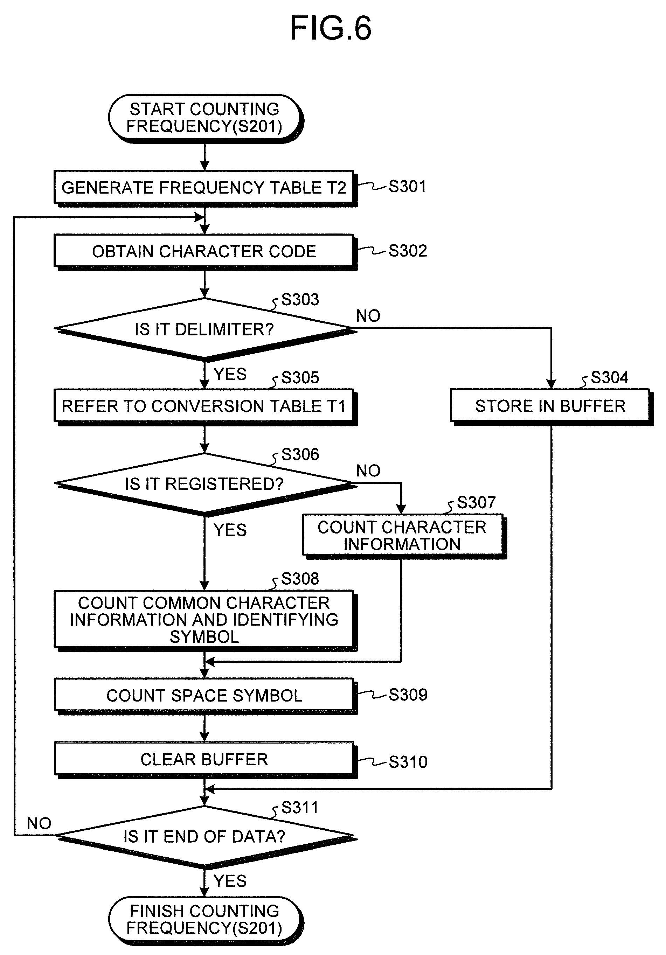

FIG. 6 is an example of a processing procedure for counting the appearance frequency. On receiving an instruction to count the appearance frequency from the controlling unit 131, the statistical unit 132 starts counting the appearance frequency in the file F1 loaded in the storage area A1. The frequency counting process is started from the reading position, which is the beginning of the file F1 loaded in the storage area A1. The statistical unit 132 first generates the frequency table T2 for storing the appearance frequency of each piece of character information, based on the word list L1 and the conversion table T1 loaded from the storage unit 15 (S301). More specifically, the statistical unit 132 sequentially registers the character information the appearance frequency of which is to be counted, in the storage area secured in the processing at S101.

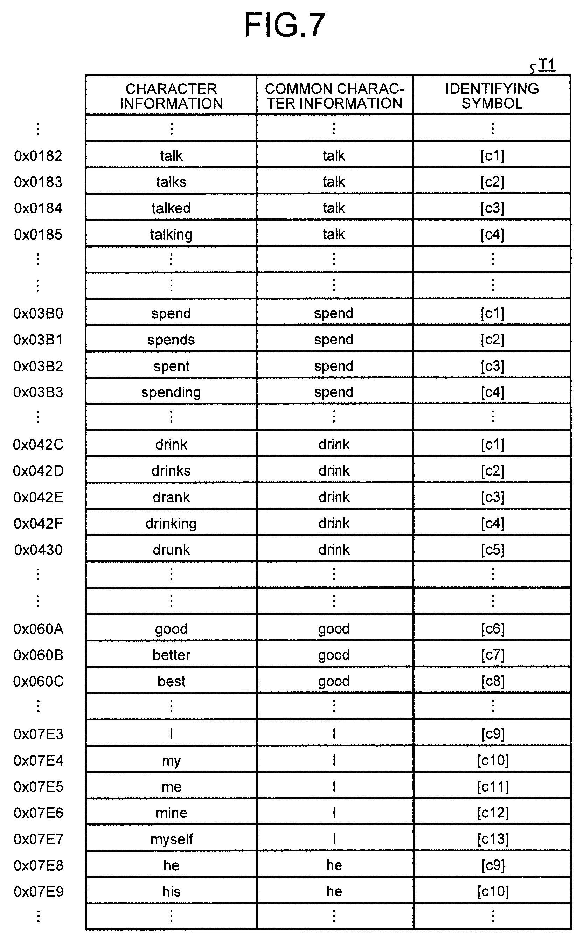

FIG. 7 is an example of a conversion table. The conversion table T1 maps the set of the common character information and the identifying symbol to the character information. The common character information indicates the common concept of the respective pieces of character information, corresponding to the multiple types of common concepts. The identifying symbols discriminate the respective pieces of character information from one another. For example, the respective pieces of character information of "talk", "talks", "talked", and "talking" are pieces of character information that correspond to the common concept of "talk". In the conversion table T1, the character information (common character information) indicating the common concept of "talk" is mapped to each of the pieces of character information of "talk", "talks", "talked", and "talking". In the conversion table T1, identifying symbols [c1], [c2], [c3], and [c4] are further mapped to the pieces of character information of "talk", "talks", "talked", and "talking" to discriminate them from one another. The identifying symbol [c1] is an identifying symbol to indicate that it is the base form of a verb. The identifying symbol [c2] is an identifying symbol to indicate that it is the third person singular of a verb. The identifying symbol [c3] is an identifying symbol to indicate that it is the past tense of a verb. The identifying symbol [c4] is an identifying symbol to indicate that it is the present participle of a verb. The values at the left hand side of the conversion table T1 indicate the offset positions where the information relating to the respective pieces of character information is stored in the conversion table T1. As the identifying symbols [c1], [c2], [c3], and [c4], empty codes in the character code system for the file F1 are used. Similarly, empty codes are also used for other identifying symbols.

The common character information of "spend" indicating the common concept is also mapped to the character information of "spend", "spends", "spent", and "spending". Similarly to "talk", "talks", "talked", and "talking", the identifying symbol [c1], the identifying symbol [c2], the identifying symbol [c3], and the identifying symbol [c4] are mapped to "spend", "spends", "spent", and "spending", respectively. For example, to the character information of "drunk", the common character information of "drink" and an identifying symbol [c5] indicating that it is the past participle of a verb, are mapped.

For example, the common character information indicating "good", which is the common concept, is mapped to adjectives of "good", "better", and "best". An identifying symbol [c6] indicating that it is the base form of an adjective, an identifying symbol [c7] indicating that it is the comparative form of an adjective, and an identifying symbol [c8] indicating that it is the superlative form of an adjective are mapped to the adjectives "good", "better", and "best", respectively. For example, the common character information indicating "I", which is the common concept, is mapped to the character information of "I", "my", "me", "mine", and "myself". An identifying symbol [c9] indicating that it is the subject form of a personal pronoun, an identifying symbol [c10] indicating that it is the possessive form of a personal pronoun, an identifying symbol [c11] indicating that it is the objective form of a personal pronoun, an identifying symbol [c12] indicating that it is the possessive pronoun, and an identifying symbol [c13] indicating that it is the reflexive pronoun are mapped to "I", "my", "me", "mine", and "myself", respectively.

For example, the conversion table T1, in which the corresponding relation between the character information and the set of the common character information and the identifying symbol is set in advance, is stored in the storage unit 15. The statistical unit 132 registers the character information registered in the word list L1 in the frequency table T2, excluding the character information registered in the conversion table T1. The statistical unit 132 also registers the common character information and the identifying symbol in the conversion table T1, in the frequency table T2.

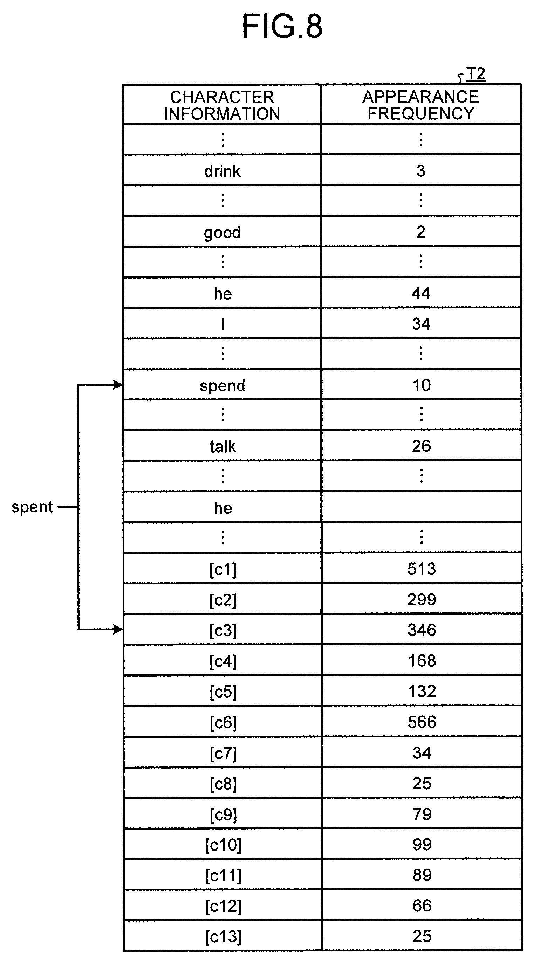

FIG. 8 is an example of the frequency table T2. The frequency table T2 is a table that maps the character information (including common character information and identifying symbol) to the appearance frequency. As described above, when the statistical unit 132 generates the frequency table T2, the character information registered in the conversion table T1 is excluded. Accordingly, the multiple types of character information corresponding to the common concept, such as "talk", "talks", "talked", and "talking", are each registered in the frequency table T2, while being divided into the common character information "talk" and each of the identifying symbols of [c1] to [c4].

Returning to the processing procedure illustrated in FIG. 6, when the character information is registered in the frequency table T2, the statistical unit 132 obtains a character code from the reading position of the storage area A1 (S302). In the processing at S302, the reading position is advanced as many as the character code obtained at S302.

The statistical unit 132 then determines whether the character code obtained at S302 is a delimiter (S303). S303 is determined by setting the character codes that serve as delimiters in advance and judging whether the character code obtained at S302 corresponds to any of the character codes set in advance. The delimiter, for example, is a space symbol (0×20 in the ASCII code system), an exclamation mark (0×21 in the ASCII code system), a comma (0×2C in the ASCII code system), a period (0×2E in the ASCII code system), a colon (0×3A in the ASCII code system), a semicolon (0×3B in the ASCII code system), and a question mark (0×3F in the ASCII code system). S303 may also be determined based on whether the character code obtained at S302 is within a predetermined value range (such as between 0×20 and 0×3F in the ASCII code system).

If the character code obtained at S302 is not the delimiter (No at S303), the statistical unit 132 stores the character code obtained at S302 in a buffer (S304). When the processing at S304 is finished, the process proceeds to S311.

If the character code obtained at S302 is a delimiter (Yes at S303), the statistical unit 132 refers to the conversion table T1 based on the character information stored in the buffer (S305). The statistical unit 132, based on the reference results at S305, determines whether the character information stored in the buffer is registered in the conversion table T1 (S306).

If the character information stored in the buffer is not stored in the conversion table T1 (No at S306), the statistical unit 132 counts the character information stored in the buffer (S307). At S307, if the frequency table T2 does not include the same character information as that stored in the buffer, the statistical unit 132 counts the character codes stored in the buffer.

If the character information stored in the buffer is stored in the conversion table T1 (Yes at S306), the statistical unit 132 counts the character information stored in the buffer and both of the common character information and the identifying symbol mapped by the conversion table T1 (S308). For example, at S308, the statistical unit 132 increments the count values mapped to both the common character information and the identifying symbol by the frequency table T2. For example, if the character information stored in the buffer is "spent", the statistical unit 132 increments the count values of both the common character information "spend" and the identifying symbol [c3].

When the processing at S307 or S308 is performed, the statistical unit 132 counts the number of delimiters obtained at S302 (S309). At S309, the statistical unit 132 increments the count values corresponding to the delimiters obtained from the frequency table T2 at S302. The statistical unit 132 then clears the buffer (S310). The order of the processing at S309 and S310 is interchangeable.

When S304 or S310 is performed, the statistical unit 132 determines whether the reading position is the end of the file F1 loaded in the storage area A1 (S311). If it is determined that it is not the end at S311 (No at S311), the statistical unit 132 proceeds to S302. If it is determined that it is the end at S311 (Yes at S311), the statistical unit 132 finishes the frequency counting process.

When the frequency counting process by the statistical unit 132 is finished, the controlling unit 131 returns to the procedure in FIG. 5, and causes the sort unit 134 to execute sorting process (S202). For example, the sort unit 134 rearranges the pieces of character information registered in the frequency table T2 (such as characters, symbols, words, common character information, and identifying symbols), based on the frequency information (appearance times of each piece of character information) generated by the statistical unit 132. For example, the sort unit 134 rearranges the pieces of character information stored in the frequency table T2, in either ascending order or descending order of the appearance times.

When the processing at S202 is finished, the controlling unit 131 causes the assignment unit 133 to assign compressed codes (S203). For example, the assignment unit 133 assigns compressed codes to the character information group rearranged in the order of appearance frequency at S202, based on the algorithm of Huffman coding or arithmetic compression, in which a shorter compressed code is assigned to the character information that appears more frequently.

When the compressed code is assigned to each piece of the character information registered in the frequency table T2, the controlling unit 131 generates a set of compressed codes corresponding to the combination of the common character information and the identifying symbol (S204). At S204, the controlling unit 131 maps the character information corresponding to the combination of the common character information and the identifying symbol registered in the conversion table T1, to the combination of compressed codes each corresponding to the combined common character information and identifying information. For example, the character information "spent" is mapped to the set of the compressed code c(spend) and the compressed code c([c3]), which corresponds to the common character information "spend" and the identifying symbol [c3] mapped in the conversion table T1. In this case, the compressed codes are combined in the order in which the compressed code c([c3]) precedes the compressed code c(spend). The controlling unit 131 also stores correspondence information obtained by mapping the respective pieces of character information registered in the word list L1 to the compressed codes corresponding to the respective pieces of character information, in the area in which the compression dictionary D1 is stored. In this correspondence information, the character information registered in the conversion table T1 is mapped to the set of compressed codes (set of the compressed code corresponding to the common character information and compressed code corresponding to the identifying symbol).

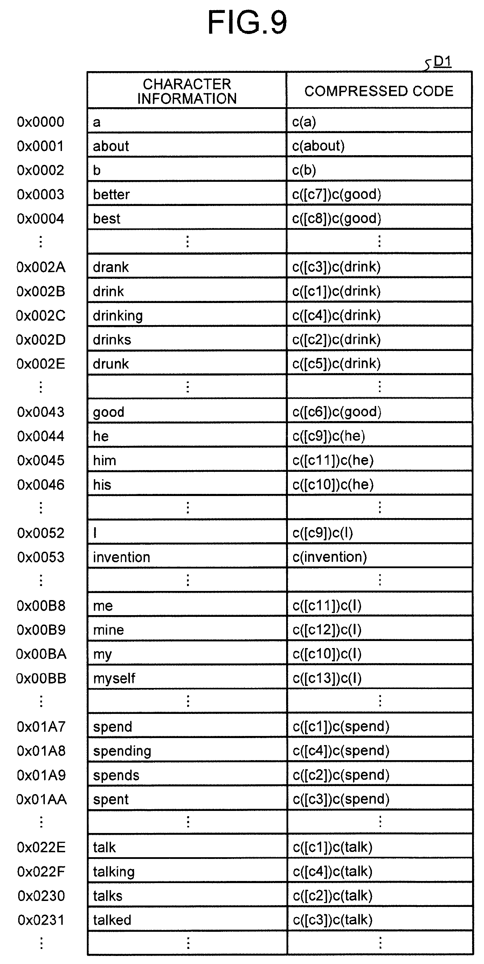

The controlling unit 131 then causes the sort unit 134 to sort the set of each piece of the character information and the compressed code mapped to each piece of the character information included in the correspondence information, based on the character code value of each piece of the character information (S205). The sort unit 134, for example, rearranges the character codes of the pieces of character information in ascending order. The sort unit 134, for example, arranges the pieces of character information in ascending order according to the character code value of the first letter. If the first letters of the pieces of character information have the same character code, the sort unit 134 arranges the pieces of character information in ascending order according to the character code value of the second letter. The state in which the rearrangement is made in the processing at S205 is the compression dictionary D1 illustrated in FIG. 9.

When the processing at S205 is finished, the controlling unit 131 generates an index (S206). The controlling unit 131 generates the index by mapping the character information to information (offset value) indicating the position of the character information in the character information group sorted at S205. For example, an offset value "0×0052" or the like is mapped to a character "i" in the compression dictionary D1 illustrated in FIG. 9. When the index is utilized in the generation of compressed codes, a search for the compressed code corresponding to the word beginning with "i" starts from "0×0052". When the processing at S206 is finished, the generation unit 13 finishes the generation of the compression dictionary D1.

FIG. 9 is an example of a data structure of a compression dictionary. The character information and the compressed codes are mapped and stored in the compression dictionary D1 illustrated in FIG. 9. The storage position of the set of the character information and the compressed codes is indicated by the offset value that sets the storage position in the compression dictionary D1 to the starting point. For example, information on the character information "invention" is stored in the offset value "0×0053". The index generated at S206 narrows down the searching range by using this offset value. As described above, "c()" indicates that it is a compressed code corresponding to the character information within the parentheses. In the example in FIG. 9, among the pieces of character information registered in the compression dictionary D1, the pieces of character information registered in the conversion table T1 are mapped to the multiple compressed codes. The character information that is not registered in the conversion table T2 is mapped to one compressed code.

The compression dictionary D1 is generated by the generation unit 13. However, as another example, the compression dictionary D1 may be stored in the storage unit 15 in advance. In this case, the compression dictionary D1 is used in common for a plurality of files. For example, in the compression dictionary D1 stored in the storage unit 15 in advance, compressed codes may be assigned based on the frequency information of the character information in the file compressed in the past (past version of a document file) or in a plurality of files that exist in the database.

When the generation unit 13 finishes the generation of the compression dictionary D1, the controlling unit 111 returns to the procedure in FIG. 4, and executes the generation of compressed data (S104).

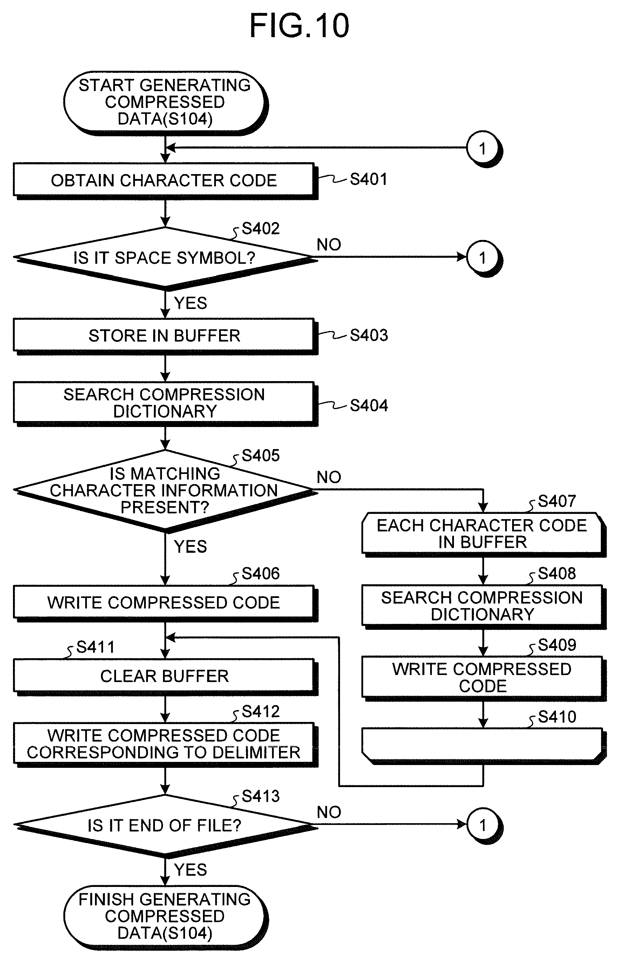

FIG. 10 is an example of a processing procedure for generating compressed data. At the beginning of generating compressed data, the reading position is set at the starting point of the file F1 loaded in the storage area A1, the writing position is set at a predetermined position in the storage area A2, and the buffer is to be cleared. The reading unit 113 obtains a character code from the reading position (S401). After the character code is obtained at S401, the controlling unit 111 updates the reading position. The controlling unit 111 then determines whether the character code obtained at S401 is a delimiter (S402). Similarly to S303, the delimiter is a character code in which a space, a comma, or the like is set in advance.

If the character code obtained at S401 is not the delimiter (No at S402), the controlling unit 111 stores the character code obtained by the reading unit 113 at S401 in the buffer (S403). When S403 is performed, the procedure returns to S401, and the reading unit 113 obtains a character code from the reading position.

If the character code obtained at S401 is the delimiter (Yes at S402), the searching unit 112 searches the compression dictionary D1 for the character code (or character code string) stored in the buffer (S404). The controlling unit 111 then determines whether matching character information that matches the character code (or character code string) stored in the buffer is present in the compression dictionary D1 (S405).

If the matching character information is present (Yes at S405), the writing unit 114 writes the compressed code mapped to the matching character information in the compression dictionary D1, at the writing position in the storage area A2 (S406). The controlling unit 111 then updates the writing position. If multiple compressed codes are mapped to the matching character information in the compression dictionary D1, the writing unit 114 writes the compressed codes in the writing position. When the writing is performed, the controlling unit 111 updates the writing position in the storage area A2, based on the written compressed code length.

If the matching character information is not present in the compression dictionary D1 (No at S405), the controlling unit 111 performs processing on each character code in the buffer (S407 to S410). The controlling unit 111 causes the searching unit 112 to search each character code in the compression dictionary D1 (S408), and causes the writing unit 114 to write the compressed code obtained as a result of the search at the writing position (S409). When the processing at S408 and S409 is finished, the processing from S407 to S410 performed on each character code stored in the buffer is also finished.

When either S406 or S410 is performed, the controlling unit 111 deletes (clears) the character code (or character code string) stored in the buffer (S411). The writing unit 114 writes the compressed code, mapped to the delimiter obtained at S401 in the compression dictionary D1, at the writing position (S412). The processing of S412 may precede S411. The controlling unit 111 then determines whether the reading position is the end of the file F1 loaded in the storage area A1 (S413).

If the reading position is not the end of the file F1 (No at S413), the procedure returns to S401, and the reading unit 113 obtains a character code from the reading position. If the reading position is the end of the file F1 (Yes at S413), the controlling unit 111 finishes the generation of compressed data.

When the above-described generation of compressed data is finished, the procedure returns to S105 in FIG. 4. The controlling unit 111 generates the compressed file F2 by using the compressed data stored in the storage area A2, and stores it in the storage unit 15 (S105). The compressed file F2, for example, is configured with a header, compressed data in the storage area A2, and trailer information. The header, for example, includes identifying information to identify the compression algorithm, and information such as data sizes of the header, compressed data, and the trailer information. The trailer information, for example, includes the conversion table T1 and the frequency table T2.

When the processing at S105 is finished, the controlling unit 111 notifies the calling destination of the compression function that the compression processing is finished (S106). The notification at S106, for example, includes information on the storage destination of the compressed file F2. When the processing at S106 is finished, the compression unit 11 finishes the compression process.

FIG. 11 is an example of a processing procedure of a decompression function. When the decompression function is called, the controlling unit 121 executes preprocessing of the decompression process (S501). The calling of the decompression function includes a specification of the compressed file F2 to be decompressed. In the preprocessing at S501, the controlling unit 121 secures the storage area A3 and the storage area A4, and further secures a storage area for a decompression dictionary D3.

When the processing at S501 is finished, the controlling unit 121 loads the compressed file F2 in the storage area A3 (S502). The controlling unit 121 then causes the generation unit 14 to generate a decompression dictionary (S503).

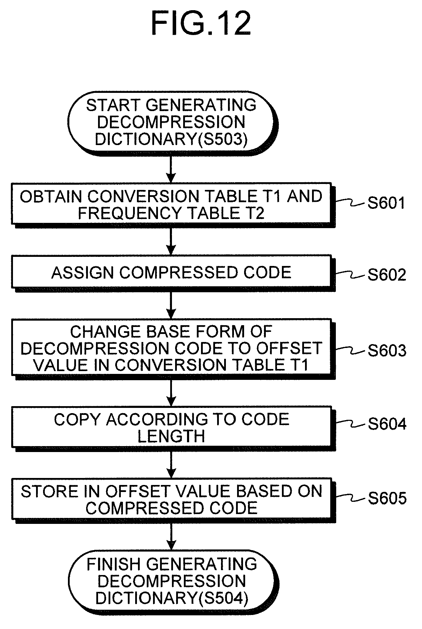

FIG. 12 is an example of a processing procedure for generating a decompression dictionary. The controlling unit 141 obtains the conversion table T1 and the frequency table T2 from the trailer information in the compressed file F2 loaded in the storage area A3 (S601). The controlling unit 141 then assigns a compressed code to each piece of the character information (including common character information and identifying symbols) registered in the frequency table T2, based on the frequency table T2 (S602). In the processing at S602, a compressed code is assigned by the algorithm similar to that at S203. The controlling unit 141, among the pieces of character information to which the compressed codes are assigned, then changes the common character information to the offset value in the obtained conversion table T1 (S603). The offset value indicates the position where the character information corresponding to the common character information is stored in the conversion table T1. For example, as for the common character information "talk", the offset value "0×0182" is stored. With this offset value "0×0182", it is possible to refer to the character information corresponding to "talk", which is the common concept of "talk", "talks", "talked", and "talking".

The sort unit 144 sorts the pieces of character information (including the offset values changed at S603) to which the compressed codes are assigned, based on the values of the compressed codes (S604). The controlling unit 141 then associates the code length of the assigned compressed code with each piece of the character information (including the offset value changed at S603) to which the compressed code is assigned.

The copying unit 143 then copies the character information and the information of the code length, to the number based on the code length associated with the character information (S605). For example, if the maximum compressed code length is set to 12 bits, the copying unit 143 copies the character information (including offset value) having the code length of n and the information on the code length, to the number of 2 raised to the power of (12 - n). The controlling unit 141 then stores the copied information at the offset position based on the compressed code, which is also the position in the storage area of the decompression dictionary D2 secured by the storage unit 15 (S606). As a result of S606, the decompression dictionary D2 is generated and the procedure proceeds to S504 in FIG. 11.

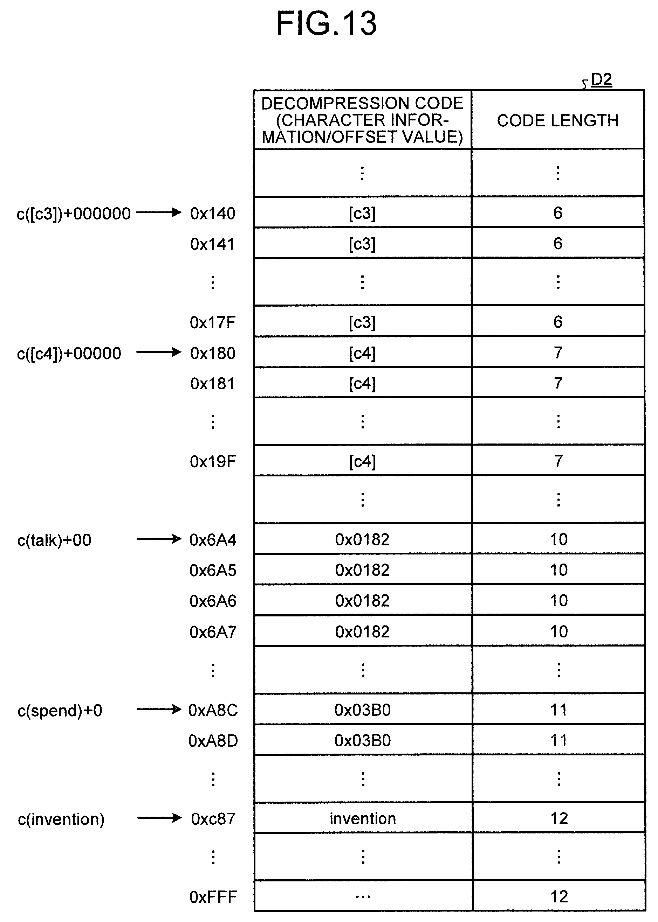

FIG. 13 is an example of a data structure of the decompression dictionary. The decompression dictionary D2 has a data structure in which the information indicating the decompression code (character information or offset value in the conversion table T1) and the code length is stored in the offset position based on the corresponding compressed code. The decompression dictionary D2 in FIG. 13 is an example, when the maximum code length of the compressed codes is 12 bits.

By using the decompression dictionary D2, it is possible to read out the fixed length data from the compressed data on which variable length coding is performed, and extract the decompression code corresponding to the fixed length data that has been read out. By reading out the fixed length data, the decompression speed can be increased, compared to when the border of codes is determined one bit at a time. As for the compressed codes shorter than 12 bits, extra data is read out from the compressed data. Accordingly, the reading position from the compressed data is adjusted based on the code length. Because the decompression dictionary D2 is a decompression dictionary used for such decompression processing, pieces of information having the same decompression code and the code length are redundantly registered.

For example, the compressed code c([c3]) corresponding to the identifying symbol [c3] in the decompression dictionary D2 is 6-bit data of "000101". However, this is read out collectively from the compressed data as 12-bit data. Among the read out 12-bit data, if the first 6 bits is "000101", the decompression code of the identifying symbol [c3] can be obtained, whatever data the latter 6 bits may have. Accordingly, by storing all the values of the decompression codes and the code lengths that the latter 6 bits may have, information such as decompression code corresponding to the 6-bit variable length code can be obtained, regardless of whatever data the latter 6 bits of the 12-bit fixed length data may have. The information of the identifying symbol [c3] is copied for all the ways (64) the latter 6 bits may have (from "000000" to "111111"). The compressed code is then stored in the offset position (000101000000(0×140)) corresponding to "000101". In other words, the information relating to the identifying symbol [c3] is stored in the 64 pieces of data in the decompression dictionary between the offset values from 0×140 to 0×17F.

Similarly to the control symbol [c3], the information relating to the common character information "talk" is also copied as many as the number according to the code length of the compressed code, and stored in the offset position according to the compressed code. However, the common character information is changed to the offset value (0×0182) in the conversion table T1 in the processing at S603.

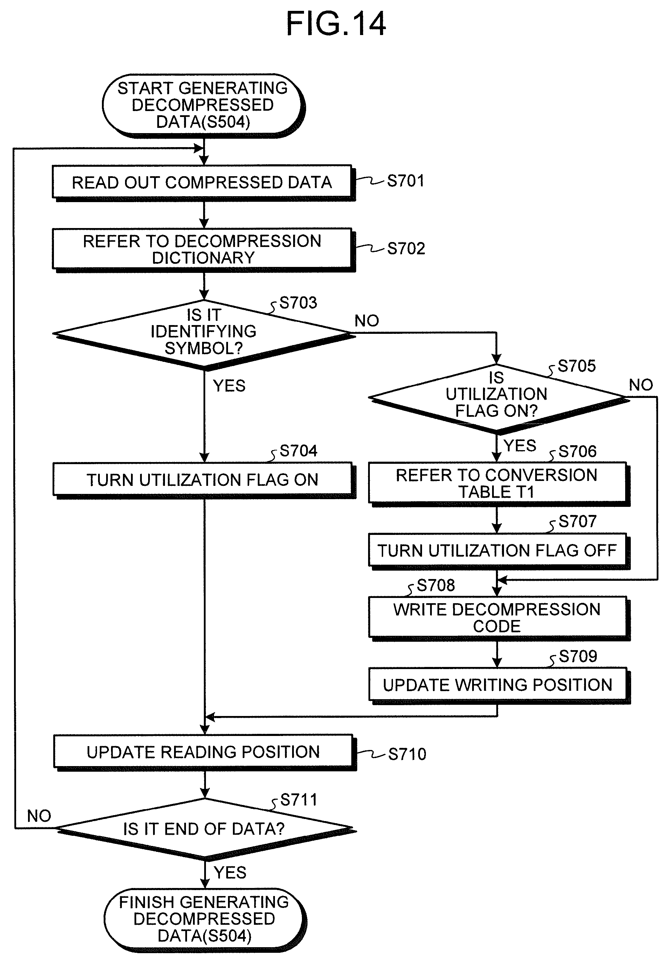

FIG. 14 is an example of a processing procedure for generating decompressed data. When the decompression dictionary D2 is generated, the controlling unit 121 starts generating decompressed data corresponding to the compressed data included in the compressed file F2. The reading position from the storage area A3 is set to the starting point of the compressed data in the file F2, and the writing position to the storage area A4 is set to a predetermined position in the storage area A4.

The reading unit 123 reads out the compressed data from the reading position in the storage area A3 (S701). As described above, the compressed data is read out by using the fixed length (for example, 12 bits). The searching unit 122 refers to the decompression dictionary D2 based on the fixed length data that has been read out (S702). The controlling unit 121 then determines whether the decompression code obtained by the reference at S702 is an identifying symbol (S703).

If the decompression code obtained by the reference at S702 is an identifying symbol (Yes at S703), the controlling unit 121 turns a utilization flag to ON (S704). The utilization flag is used to determine whether the decompression code mapped to the compressed code in the decompression dictionary D2 is character information or an offset value. At S704, the controlling unit 121 stores the identifying symbol obtained by the reference at S702 in the buffer.

If the decompression code obtained by the reference at S702 is not an identifying symbol (No at S703), the controlling unit 121 determines whether the utilization flag is turned ON (S705). If the utilization flag is turned ON (Yes at S705), the searching unit 122 refers to the conversion table T1 (S706). At S706, the searching unit 122 refers to the conversion table T1 based on the offset value, by using the decompression code obtained by the reference at S702 as the offset value in the conversion table T1. The searching unit 122 then obtains the character information corresponding to a combination of the identifying symbol stored in the buffer and common character information indicated by the offset value (decompression code), from the conversion table T1. The controlling unit 121 then turns the utilization flag to OFF, and deletes the identifying symbol stored in the buffer (S707) .

If the utilization flag is turned OFF at S705 (No at S705), or when the processing at S707 is finished, the controlling unit 121 writes the character information at the writing position in the storage area A4 (S708). The character information to be written at S708 is either the decompression code obtained by the reference to the decompression dictionary D2 at S702, or the character information obtained by the reference to the conversion table T1 at S706. The controlling unit 121 then updates the writing position at the storage area A4, based on the length of the character information written at S708 (S709).

When the processing at S704 or S709 is performed, the controlling unit 121 updates the reading position from the storage area A3 (S710). The reading position from the storage area A3 is updated based on the code length obtained by the reference at S702. For example, the reading position is advanced as many as the number of bits indicating the code length information.

The controlling unit 121 then determines whether the reading position from the storage area A3 is the end of the compressed data in the compressed file F2 (S711). If the reading position from the storage area A3 is not the end of the compressed data (No at S711), the procedure returns to S701, and the reading unit 123 reads out the compressed data again. If the reading position from the storage area A3 is the end of the compressed data (Yes at S711), the controlling unit 121 finishes the generation of decompressed data, and the procedure proceeds to S505.

The decompression dictionary D2 is one example of decompression dictionary. As another example, a decompression dictionary in which the same information is not redundantly registered may also be used. For example, a decompression dictionary using the general Huffman coding may be used. Even in such a case, when the decompression code is obtained from the decompression dictionary, the controlling unit 121 performs the processing at S703, and based on the determination result, the controlling unit 121 performs either the processing at S704 or the processing from S705 to S709.

When the generation of decompressed data is finished, the controlling unit 121 generates the decompressed file F3 based on the decompressed data stored in the storage area A4, and stores the generated decompressed file F3 in the storage unit 15 (S505). The controlling unit 121 then notifies the calling destination of the decompression function that the decompression processing is finished (S506). The notification at S506, for example, includes information indicating the storage destination of the decompressed file F3. When the processing at S506 is finished, the decompression unit 12 finishes the decompression process.

### [Conversion to Compression Codes]

In example (3) and example (6) illustrated in FIG. 2, a combination of the compressed code corresponding to the identifying symbol and the compressed code corresponding to the common character information is used. In this combination, the compressed code corresponding to the identifying symbol precedes the compressed code corresponding to the common character information. Because of this order, the identifying symbol is read out first from the decompression dictionary D1. Accordingly, it is possible to determine whether the decompression code obtained from the decompression dictionary D1 is character information or an offset value, based on the compressed code read out after the identifying symbol.

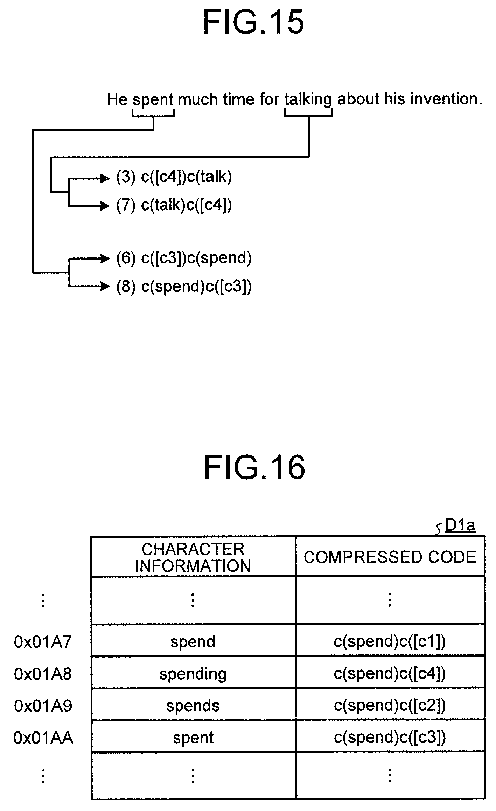

FIG. 15 is an example of conversion to compressed codes. As illustrated in example (3), the compressed code corresponding to the identifying symbol may precede. However, as illustrated in example (7), the compressed code corresponding to the common character information may also precede. Similarly to example (7), example (8) also illustrates an example in which the compressed code corresponding to the common character information precedes the compressed code corresponding to the identifying symbol.

In the processing at S204 in FIG. 5, the compression dictionary D1 illustrated in FIG. 9 is generated by controlling the compressed code corresponding to the identifying symbol to precede the compressed code corresponding to the common character information. To arrange the compressed codes in the order as indicated in example (7) and example (8) illustrated in FIG. 15, the compressed code corresponding to the common character information may be controlled to precede the compressed code corresponding to the identifying symbol, in the processing at S204 in FIG. 5.

FIG. 16 is an example of a data structure of a compression dictionary. In a compression dictionary D1a illustrated in FIG. 16, the order of the combination of the compressed codes mapped to the character information registered in the conversion table T1 is reversed from that in the compression dictionary D1. In other words, the compressed code corresponding to the common character information precedes the compressed code corresponding to the identifying symbol.

In the compression dictionary D1a, similarly to the compression dictionary D1, the compressed codes are mapped to the character information. In FIG. 16, the content related only to the character information "spend", "spends", "spent", and "spending" in the compression dictionary D1a is depicted. For example, as for the character information "spent", the compressed code c(spend) and the compressed code c([c3]) are arranged in the order of c(spend)c([c3]). When the compression dictionary D1a is used to generate compressed data as in FIG. 10, the order of the compressed codes in the compression dictionary D1a is directly reflected to the compressed data. Consequently, the compressed codes are also arranged in the order of c(spend)c([c3]) in the compressed file F2.

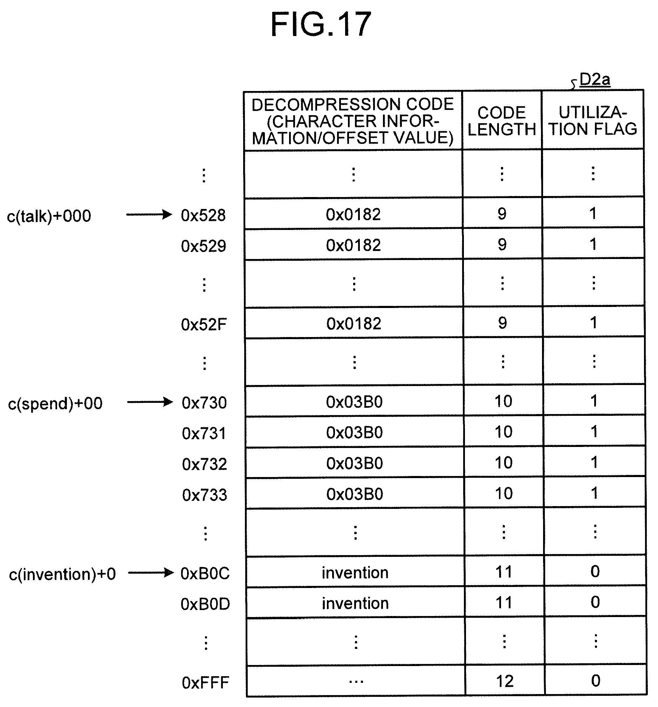

FIG. 17 is an example of a data structure of a decompression dictionary. In a decompression dictionary D2a illustrated in FIG. 17, in addition to the decompression code (character information or offset value) and the code length, a utilization flag is also mapped thereto. In the decompression dictionary D2a, the offset value in the conversion table T1, the code lengths of the compressed code, and the utilization flag in the ON state, are mapped to the compressed code corresponding to the common character information. When the decompression dictionary D2a is referred to based on the compressed code corresponding to the common character information, it is possible to judge that the decompression code is the offset value, because the utilization flag is turned ON. The compressed code corresponding to the character information, which is not the common character information, is mapped to the character information, the code length of the compressed code, and the utilization flag in the OFF state.

When the decompression dictionary D2a is used, it is possible to judge that the compressed code corresponds to the common character information, by referring to the utilization flag in the decompression dictionary D2a. It is also possible to judge that the identifying symbol is to be obtained next. Consequently, there is no need to consider the competition between the compressed code corresponding to the identifying symbol and the compressed code corresponding to the character information. In other words, in example (7) and example (8) in FIG. 15, the compressed code corresponding to the identifying symbol may be uniquely assigned, instead of using the code assignment algorithm applied at S203 and the like. As a result, the types of character information to which compressed codes are assigned by the code assignment algorithm are reduced. Particularly, because identifying symbols are used in common for multiple pieces of character information (the past tense of verbs is indicated by the identifying symbol [c3]), they appear frequently. Hence, when the variable length compressed codes are assigned with other character information, short compressed codes are apt to be assigned. On the other hand, the compressed codes assigned to other character information are apt to be long. Consequently, by uniquely assigning the compressed code to the identifying symbol (separately from character information), the code length of the compressed code assigned to the character information tends to be short.

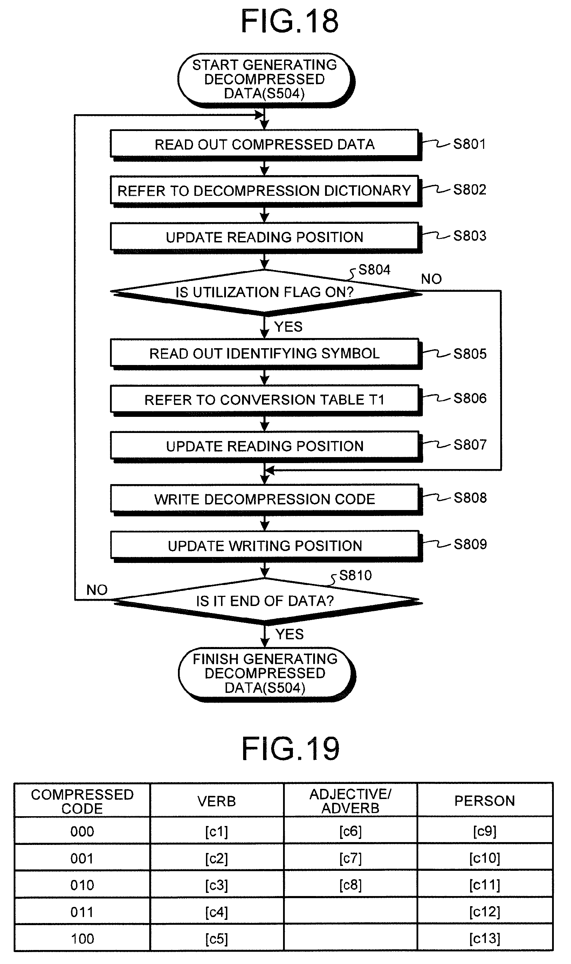

It is also possible to uniquely assign a short compressed code to the identifying symbol. For example, if an identifying symbol enables up to eight types of identification, a 3-bit fixed length code may be assigned. The assignment of fixed length codes will be described later by using FIG. 19.

FIG. 18 is an example of a processing procedure for generating decompressed data. A mechanism of determining whether the decompression code is character information or an offset value in the conversion table T1, is different between the decompression dictionary D2a and the decompression dictionary D2. When the decompression dictionary D2a is generated, the controlling unit 121 starts generating decompressed data corresponding to the compressed data included in the compressed file F2. The reading position from the storage area A3 is set at the start point of the compressed data in the file F2. The writing position to the storage area A4 is set to a predetermined position in the storage area A4.

The reading unit 123 reads out compressed data from the reading position of the storage area A3 (S801). As described above, the compressed data is read out by using fixed length data (for example, 12 bits). The searching unit 122 refers to the decompression dictionary D2a, based on the fixed length data that has been read out (S802). The controlling unit 121 then updates the reading position from the storage area A3 (S803). The reading position from the storage area A3 is updated based on the code length obtained by the reference at S802.

The controlling unit 121 then determines whether the utilization flag obtained by the reference at S802 is turned ON (S804). If the utilization flag is turned ON (Yes at S804), the reading unit 123 reads out the compressed code corresponding to the identifying symbol from the reading position of the storage area A3 (S805). The controlling unit 121 then obtains an identifying symbol based on the compressed code that has been read out.

The searching unit 122 refers to the conversion table T1, based on the offset value obtained by the reference at S802 and the identifying symbol obtained at S805 (S806). At S806, the searching unit 122 obtains the character information indicated by the offset value (decompression code) and the identifying symbol, from the conversion table T1. The controlling unit 121 updates the reading position of the storage area A3 based on the code length of the compressed code read out at S805 (S807).

When the utilization flag is turned OFF at S804 (No at S804), or when the processing at S807 is finished, the controlling unit 121 writes the character information at the writing position in the storage area A4 (S808). The character information to be written at S808 is either the decompression code obtained by the reference to the decompression dictionary D2a at S802, or the character information obtained by the reference to the conversion table T1 at S806. The controlling unit 121 then updates the writing position to the storage area A4, based on the length of the character information written at S808 (S809).

The controlling unit 121 then determines whether the reading position from the storage area A3 is the end of the compressed data in the compressed file F2 (S810). If the reading position from the storage area A3 is not the end of the compressed data (No at S810), the procedure returns to S801, and the reading unit 123 reads out the compressed data again. If the reading position from the storage area A3 is the end of the compressed data (Yes at S810), the controlling unit 121 finishes the generation of decompressed data, and the procedure proceeds to S505.

According to the conversion table T1 illustrated in FIG. 7, identifying symbols [c1] to [c5] are used for verbs, identifying symbols [c6] to [c8] are used for adjectives, and identifying symbols [c9] to [c13] are used for pronouns. For example, the identifying symbols [c6] to [c13] are not used for the character information for which the identifying symbol [c1] is used. Accordingly, even if the compressed code assigned to the identifying symbol competes with the compressed code assigned to one of the identifying symbols [c6] to [c13], character information can be identified by the combination of the compressed code corresponding to the common character information and the compressed code corresponding to the identifying symbol [c1]. In other words, compressed codes that can be mutually identified in the identifying symbols [c1] to [c5], may be assigned to the identifying symbols [c1] to [c5]. Compression codes that can be mutually identified in the identifying symbols [c6] to [c8], may be assigned to the identifying symbols [c6] to [c8]. Similarly, compressed codes that can be mutually identified in the identifying symbols [c9] to [c13], may be assigned to the identifying symbols [c9] to [c13].

FIG. 19 is an example of an assignment of compressed codes. To assign a fixed length code to an identifying symbol, compressed codes that can identify the five types of identifying symbols [c1] to [c5] (or [c9] to [c13]) may be assigned. For example, in the example in FIG. 19, a 3-bit fixed length compressed code is assigned to each identifying symbol.

In FIG. 19, five types of compressed codes "000", "001", "010", "011", and "100" are illustrated as examples. The fixed length compressed code "000" is assigned in common to the identifying symbol [c1], the identifying symbol [c6], and the identifying symbol [c9]. The fixed length compressed code "001" is assigned in common to the identifying symbol [c2], the identifying symbol [c7], and the identifying symbol [c10]. The fixed length compressed code "010" is assigned in common to the identifying symbol [c3], the identifying symbol [c8], and the identifying symbol [c11]. The fixed length compressed code "011" is assigned in common to the identifying symbol [c4] and the identifying symbol [c12]. The fixed length compressed code "100" is assigned in common to the identifying symbol [c5] and the identifying symbol [c13]. In the identifying symbols to which the common fixed length code is assigned, the pieces of character information to be identified do not compete with each other (because parts of speech are different). Accordingly, even if the compressed codes may compete with each other, the character information can be easily obtained by referring to the conversion table T1 (S706 or S806), while the decompressed data is generated. For example, in the conversion table T1, the character information "spent" can be obtained by searching the common character information "spend" and character information whose compressed code of the identifying information is "010". The compressed code "010" also corresponds to the identifying symbol [c3] and the identifying symbol [c8]. However, in the conversion table T1, the only identifying symbol that can be associated with the common character information "spend" is only [c3]. Thus, the identifying symbol [c3] is specified.

### [Corresponding to Words that Inflect Regularly]

According to the method described above, the pieces of character information written differently are obtained by referring to the conversion table T1 during the decompression process. Some verbs and adjectives inflect irregularly, but some follow a common inflection pattern. If there is the common inflection pattern, it is possible to specify the inflected word, by inflecting the basic form of a word according to the inflectional rules. If it is possible to reproduce the original character information by inflecting the common character information by following a rule during decompression, there is no need to refer to the conversion table T1. Consequently, the compressed file F2 does not need to include the information relating to the character information that inflects regularly in the conversion table T1. When the information excluding the information relating to the character information that inflects regularly in the conversion table T1 is included in the compressed file F2 , the data size of the trailer information is reduced. As a result, the file size of the entire compressed file F2 is reduced. In this case, a regular inflection flag is turned ON for a piece of common character information that is not registered in the conversion table retrieved from the compressed file F2, among the pieces of common character information registered in the frequency table T2.

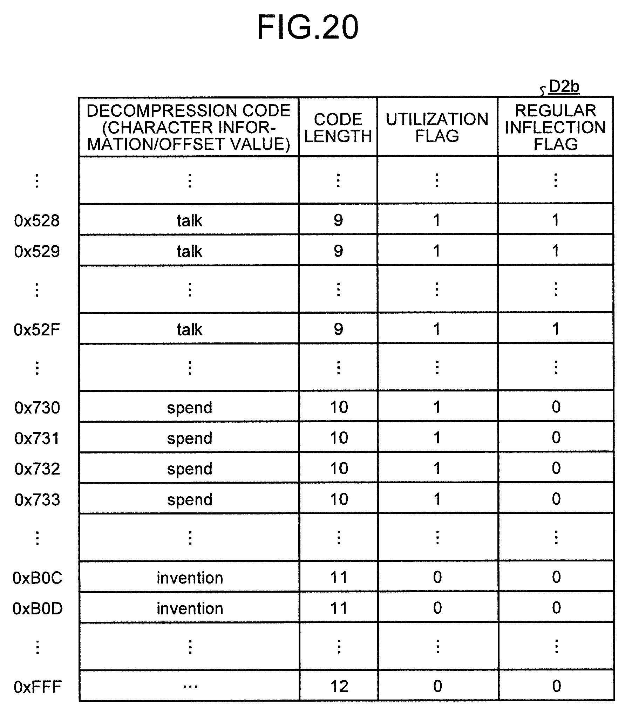

FIG. 20 is an example of a data structure of a decompression dictionary. In a decompression dictionary D2b illustrated in FIG. 20, a decompression code (character information) is associated with the code length of compressed code, the utilization flag, and the regular inflection flag. The regular inflection flag indicates whether the associated character information is character information that inflects regularly. The character information associated with a regular inflection flag in the ON state is character information that inflects regularly (verb such as "talk"). On the other hand, the character information associated with a regular inflection flag in the OFF state is character information that inflects irregularly (verb such as "spend"), or the character information that does not inflect (such as common noun). For example, the regular inflection flags expand the conversion table T1, and are set to the respective pieces of character information registered in the conversion table T1. When the decompression dictionary D2b is generated, the character information with which the regular inflection flag is set is specified from the conversion table T1, and the regular inflection flag in the decompression dictionary D2b is turned ON for the specific character information. Because the decompression on character information that inflects regularly is executed by algorithm instead of referring to the table, a part of the decompressed data generation process illustrated in FIG. 18 is extended.

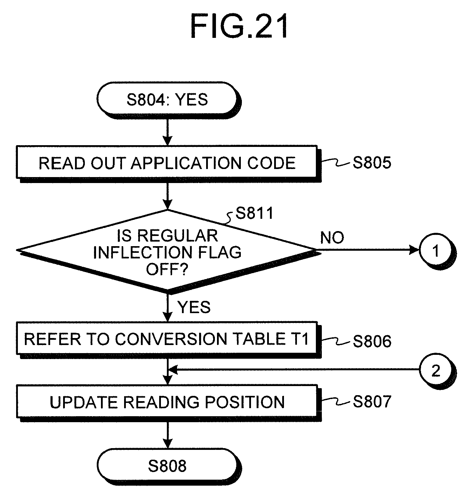

FIG. 21 is an example of a processing procedure for generating decompressed data. At S804, if it is determined that the utilization flag is turned ON (Yes at S804), the reading unit 123 reads out the compressed code corresponding to the identifying symbol (S805). The controlling unit 121 then determines whether the regular inflection flag to be referred to, when the decompression dictionary D2b is referred to at S802, is turned OFF (S811).

If the regular inflection flag is turned OFF (Yes at S811), the processing at S806 in which the conversion table T1 is referred to based on the identifying symbol and the offset value is performed (S806). When the processing at S806 is performed, the processing at S807 is subsequently performed.

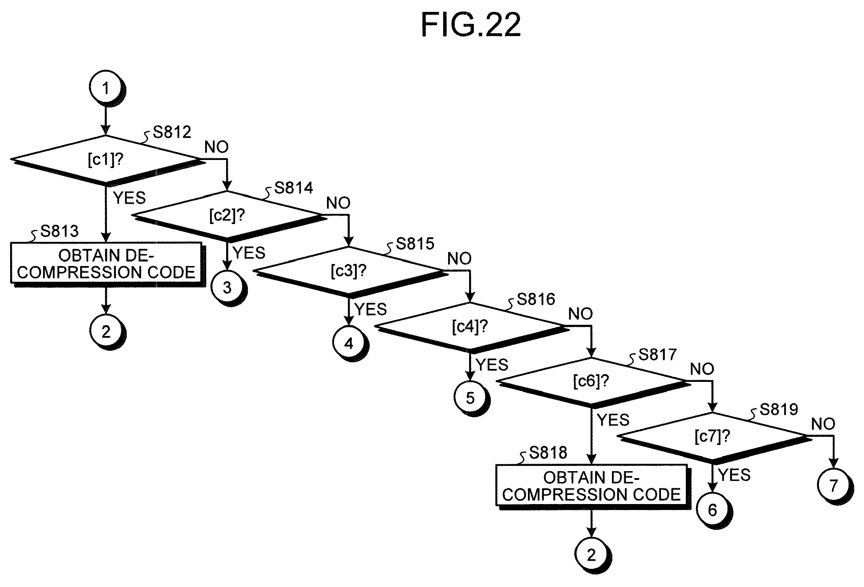

FIG. 22 is an example of a processing procedure for generating decompressed data. If the regular inflection flag is turned ON (No at S811), the controlling unit 121 determines whether the identifying symbol corresponding to the compressed code read out at S805 is [c1] (S812). If it is determined to be the identifying symbol [c1] at S812 (Yes at S812), the controlling unit 121 obtains the decompression code (character information) corresponding to the compressed data read out from the decompression dictionary D2b at S801 (S813). When the processing at S813 is performed, the processing at S807 is subsequently performed. If it is determined not to be the identifying symbol [c1] at S812 (No at S812), it is determined whether the identifying symbol corresponding to the compressed code read out at S805 is [c2] (S814). If it is determined not to be the identifying symbol [c2] at S814 (No at S814), it is determined whether the identifying symbol corresponding to the compressed code read out at S805 is [c3] (S815). If it is determined not to be the identifying symbol [c3] at S815 (No at S815), it is determined whether the identifying symbol corresponding to the compressed code read out at S805 is [c4] (S816). If it is determined not to be the identifying symbol [c4] at S816 (No at S816), it is determined whether the identifying symbol corresponding to the compressed code read out at S805 is [c5] (S817). If it is determined to be the identifying symbol [c6] at S817 (Yes at S817), the controlling unit 121 obtains the decompression code (character information) corresponding to the compressed data read out from the decompression dictionary D2b at S801 (S818). When the processing at S818 is performed, the processing at S807 is subsequently performed. If it is determined not to be the identifying symbol [c6] at S817 (No at S817), it is determined whether the identifying symbol corresponding to the compressed code read out at S805 is [c7] (S819).

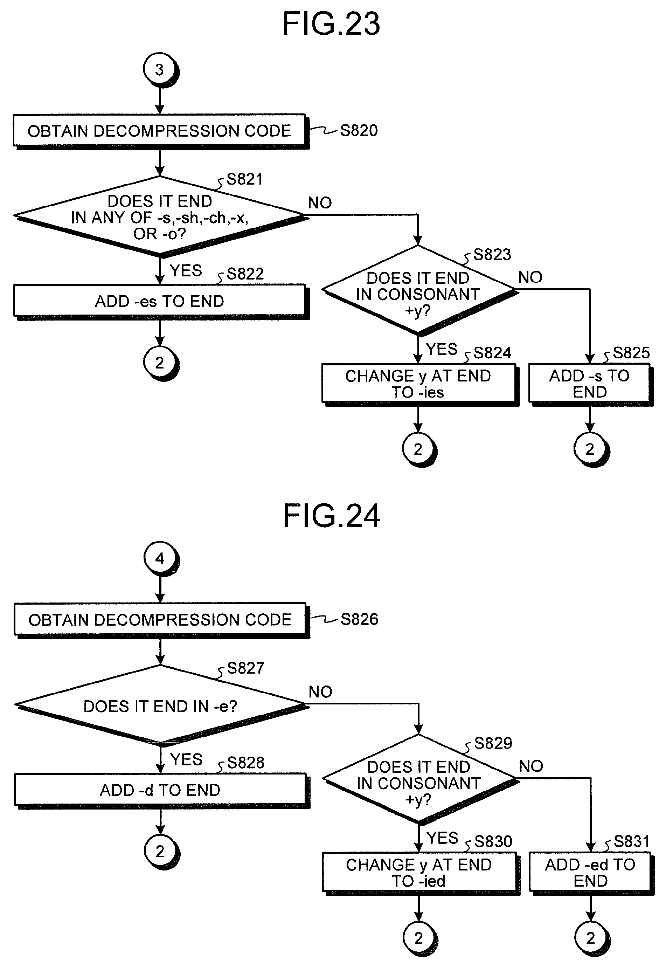

FIG. 23 is an example of a processing procedure for generating decompressed data. If it is determined to be the identifying symbol [c2] at S814 (Yes at S814), the controlling unit 121 obtains the decompression code (character information) corresponding to the compressed data read out from the decompression dictionary D2b at S801 (S820). Subsequently, the controlling unit 121 determines whether the end of the character information obtained at S820 is any one of "s", "sh", "ch", "x" or "o" (S821). At S821, if it is determined that it corresponds to one of them (Yes at S821), the controlling unit 121 adds "es" to the character information obtained at S820 (S822). When the processing at S822 is performed, the processing at S807 is subsequently performed.

At S821, if it is determined that it does not correspond to any of them (No at S821), the controlling unit 121 determines whether the end of the character information obtained at S820 is a consonant (alphabets other than "a", "e", "i", "u", and "o") followed by "y" (S823). At S823, if it is determined that the character information ends in a consonant followed by "y" (Yes at S823), the controlling unit 121 changes the end of the character information obtained at S820 from "y" to "ies" (S824). When the processing at S824 is performed, the processing at S807 is subsequently performed.

At S823, if it is determined that the character information does not end in a consonant followed by "y" (No at S823), the controlling unit 121 adds "s" to the end of the character information obtained at S820 (S825). When the processing at S825 is performed, the processing at S807 is subsequently performed.

FIG. 24 is an example of a processing procedure for generating decompressed data. If it is determined to be the identifying symbol [c3] at S815 (Yes at S815), the controlling unit 121 obtains the decompression code (character information) corresponding to the compressed data read out from the decompression dictionary D2b at S801 (S826). Subsequently, the controlling unit 121 determines whether the end of the character information obtained at S826 is "e" (S827). At S827, if it is determined that the end of the character information obtained at S826 is "e" (Yes at S827), the controlling unit 121 adds "d" to the character information obtained at S826 (S828). When the processing at S828 is performed, the processing at S807 is subsequently performed.

At S827, if it is determined that the end of the character information obtained at S826 is not "e" (No at S827), the controlling unit 121 determines whether the end of the character information obtained at S826 is a consonant followed by "y" (S829). At S829, if it is determined that the character information ends in a consonant followed by "y" (Yes at S829), the controlling unit 121 changes the end of the character information obtained at S826 from "y" to "ied" (S830). When the processing at S830 is performed, the processing at S807 is subsequently performed.

At S829, if it is determined that the character information does not end in a consonant followed by "y" (No at S829), the controlling unit 121 adds "ed" to the end of the character information obtained at S826 (S831). When the processing at S831 is performed, the processing at S807 is subsequently performed.

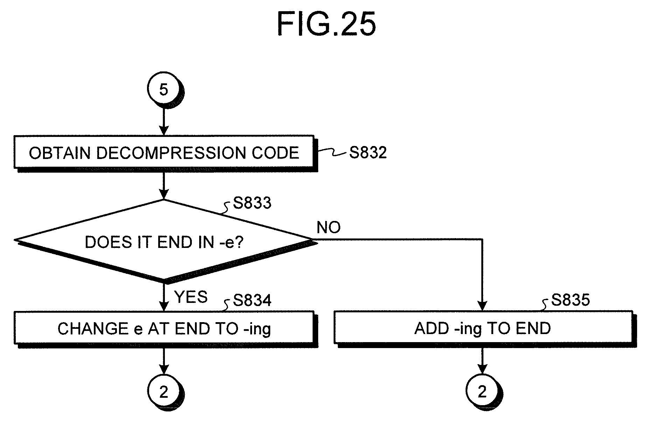

FIG. 25 is an example of a processing procedure for generating decompressed data. If it is determined to be the identifying symbol [c4] at S816 (Yes at S816), the controlling unit 121 obtains the decompression code (character information) corresponding to the compressed data read out from the decompression dictionary D2b at S801 (S832). Subsequently, the controlling unit 121 determines whether the end of the character information obtained at S832 is "e" (S833). At S833, if it is determined that the end of the character information obtained at S832 is "e" (Yes at S833), the controlling unit 121 changes the end of the character information obtained at S832 from "e" to "ing" (S834). When the processing at S834 is performed, the processing at S807 is subsequently performed.

At S833, if it is determined that the end of the character information obtained at S832 is not "e" (No at S833), the controlling unit 121 adds "ing" to the end of the character information obtained at S832 (S835). When the processing at S835 is performed, the processing at S807 is subsequently performed.

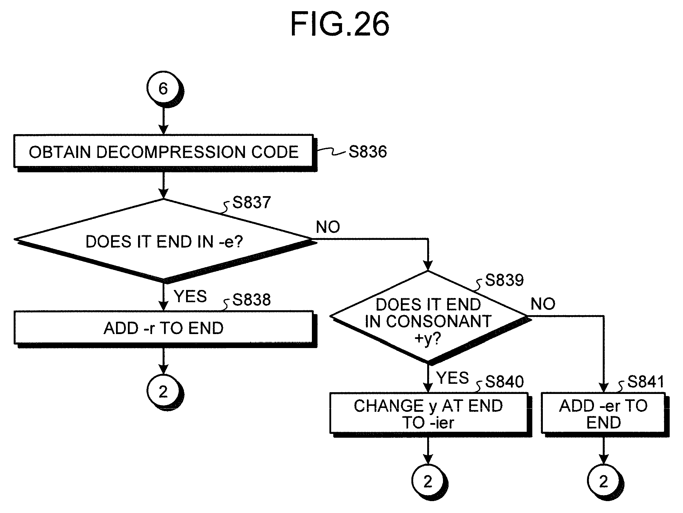

FIG. 26 is an example of a processing procedure for generating decompressed data. If it is determined to be the identifying symbol [c7] at S819 (Yes at S819), the controlling unit 121 obtains the decompression code (character information) corresponding to the compressed data read out from the decompression dictionary D2b at S801 (S836). Subsequently, the controlling unit 121 determines whether the end of the character information obtained at S836 is "e" (S837). At S837, if it is determined that the end of the character information obtained at S836 is "e" (Yes at S837), the controlling unit 121 adds "r" to the character information obtained at S836 (S838). When the processing at S838 is performed, the processing at S807 is subsequently performed.

At S837, if it is determined that the end of the character information obtained at S836 is not "e" (No at S837), the controlling unit 121 determines whether the end of the character information obtained at S836 is a consonant followed by "y" (S839). At S839, if it is determined that the character information ends in a consonant followed by "y" (Yes at S839), the controlling unit 121 changes the end of the character information obtained at S836 from "y" to "ier" (S840). When the processing at S840 is performed, the processing at S807 is subsequently performed.

At S839, if it is determined that the character information does not end in a consonant followed by "y" (No at S839), the controlling unit 121 adds "er" to the end of the character information obtained at S836 (S841). When the processing at S841 is performed, the processing at S807 is subsequently performed.

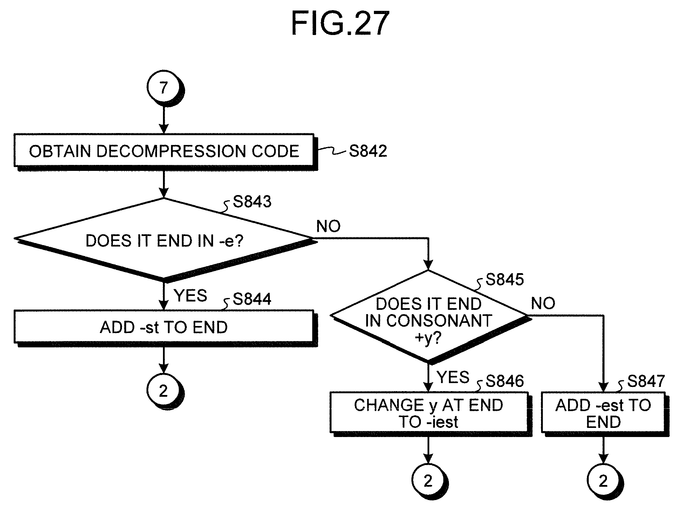

FIG. 27 is an example of a processing procedure for generating decompressed data. If it is determined not to be the identifying symbol [c7] at S819 in FIG. 22 (No at S819), the controlling unit 121 obtains the decompression code (character information) corresponding to the compressed data read out from the decompression dictionary D2b at S801 (S842). Subsequently, the controlling unit 121 determines whether the end of the character information obtained at S842 is "e" (S843). At S843, if it is determined that the end of the character information obtained at S842 is "e" (Yes at S843), the controlling unit 121 adds "st" to the character information obtained at S842 (S844). When the processing at S844 is performed, the processing at S807 is subsequently performed.

At S843, if it is determined that the end of the character information obtained at S842 is not "e" (No at S843), the controlling unit 121 determines whether the end of the character information obtained at S842 is a consonant followed by "y" (S845). At S845, if it is determined that the character information ends in a consonant followed by "y" (Yes at S845), the controlling unit 121 changes the end of the character information obtained at S842 from "y" to "iest" (S846). When the processing at S846 is performed, the processing at S807 is subsequently performed.

At S845, if it is determined that the character information does not end in a consonant followed by "y" (No at S845), the controlling unit 121 adds "est" to the end of the character information obtained at S842 (S847). When the processing at S847 is performed, the processing at S807 is subsequently performed.

### [Means for Implementing the Present Embodiment]

A configuration for executing the above described compression processing and the decompression processing will now be described below.

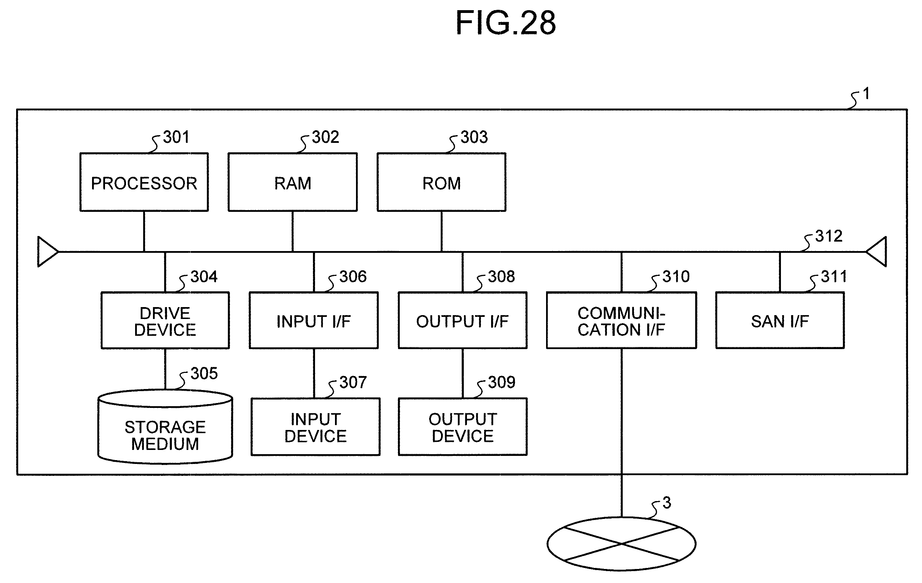

FIG. 28 is a configuration example of hardware in the computer 1. The computer 1, for example, includes a processor 301, random access memory (RAM) 302, read only memory (ROM) 303, a drive device 304, storage medium 305, an input interface (I/F) 306, an input device 307, an output interface (I/F) 308, an output device 309, a communication interface (I/F) 310, a storage area network (SAN) interface (I/F) 311, and a bus 312. The pieces of hardware are connected to each other via the bus 312.

The RAM 302 is a readable and writeable memory device, and for example, semiconductor memory such as static RAM (SRAM) and dynamic RAM (DRAM), or flash memory and the like instead of the RAM may be used. The ROM 303 may be programmable ROM (PROM) and the like. The drive device 304 is a device that performs at least one of reading and writing of information recorded in the storage medium 305. The storage medium 305 stores therein information written by the drive device 304. The storage medium 305, for example, is storage medium such as a hard disk, flash memory such as a solid state drive (SSD), a compact disc (CD), a digital versatile disc (DVD), and a Blu-ray disc. For example, the computer 1 provides the drive device 304 and the storage medium 305 for each of a plurality of types of storage media.

The input interface 306 is connected to the input device 307, and is a circuit that transmits input signals received from the input device 307 to the processor 301. The output interface 308 is connected to the output device 309, and is a circuit that causes the output device 309 to output according to an instruction from the processor 301. The communication interface 310 is a circuit that controls the communication via a network 3. The communication interface 310, for example, is a network interface card (NIC). The SAN interface 311 is a circuit that controls the communication between the computer 1 and the connected storage device through a storage area network (SAN) 4. The SAN interface 311, for example, is a host bus adapter (HBA).

The input device 307 is a device that transmits input signals according to the operation. The input signal, for example, is a keyboard, a key device such as a button mounted on the main body of the computer 1, and a pointing device such as a mouse and a touch panel. The output device 309 is a device that outputs information according to the control of the computer 1. The output device 309 is an image output device (display device) such as a display, and a speech output device such as a speaker. For example, an input/output device such as a touch screen may be used as the input device 307 and the output device 309. The input device 307 and the output device 309 may be integrated with the computer 1, or may be a device not included in the computer 1, but for example, connected to the computer 1 from outside in a wired or wireless manner.

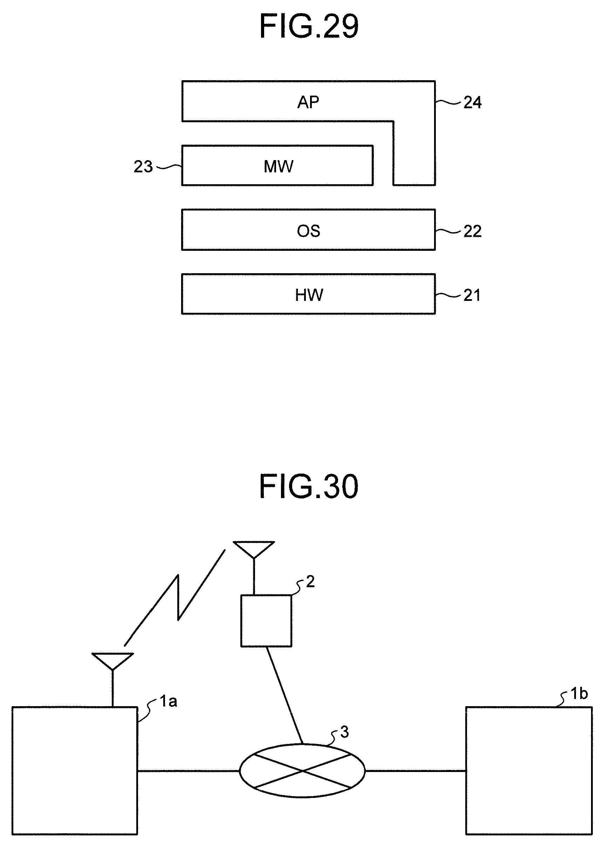

For example, the processor 301 reads out the computer program stored in the ROM 303 and the storage medium 305 to the RAM 302, and performs at least one of processes by the compression unit 11, the decompression unit 12, the generation unit 13, and the generation unit 14, according to the procedure of the read-out program. In such case, the RAM 302 is used as a work area of the processor 301. The functions of the storage unit 15 are achieved, when the ROM 303 and the storage medium 305 store program files (such as an application program 24, middleware 23, and an operation system (OS) 22, which will be described later) and data files (such as the file F1, the compressed file F2, and the decompressed file F3) therein, and when the RAM 302 is used as a work area of the processor 301. The computer programs to be read out by the processor 301 will be described by referring to FIG. 29.

FIG. 29 is a configuration example of computer programs operated in the computer 1. The application program 24 or the middleware 23 is a computer program in which the processing procedure of the compression function or the decompression function of the present embodiment is prescribed. In other words, the application program 24 or the middleware 23 is a computer program in which the processing procedure of generating the compression dictionary or the decompression dictionary of the present embodiment is prescribed.

The compression program in which the processing procedure of the compression function is prescribed and the decompression program in which the processing procedure of the decompression function is prescribed may be integrated with each other or separate programs. The compression dictionary generation program, in which the procedure for generating the compression dictionary is prescribed, may be included in a compression program or a separate program called by the compression program. The decompression dictionary generation program, in which the procedure for generating a decompression dictionary is prescribed, may be included in the decompression program or a separate program read out by the decompression program. At least one of the compression function and the decompression function of the present embodiment may be provided as one function of the OS 22.

For example, at least one of the compression function and the decompression function, and at least one of the compression program, the decompression program, the compression dictionary generation program, and the decompression dictionary generation program described above are stored in the storage medium. For example, a computer program stored in the storage medium becomes executable, when the computer program stored in the storage medium is read out by the drive device 304 and is installed. Each of the processing procedures prescribed in the installed program is executed when a hardware group 21 (301 to 312) is controlled based on the OS 22.

The function of each of the functional blocks included in the computer 1 illustrated in FIG. 3, is provided when the processor 301 executes the compression program or the decompression program. The function of each functional block included in the compression unit 11 and the generation unit 13 is provided, when the processor 301 executes each processing procedure of the compression program. The function of each functional block included in the decompression unit 12 and the generation unit 14 is provided, when the processor 301 executes the processing procedure of the decompression program.

For example, the functional blocks in the compression unit 11 are executed by using the hardware group 21 as follows. The function of the controlling unit 111 is provided, when the processor 301 accesses the RAM 302 (such as securing a storage area and loading a file), manages the processing status (such as the reading position and the writing position) in the register, and performs matching determination on the information held in the register. The function of the reading unit 113 is provided when the processor 301 accesses the RAM 302 according to the processing status in the register. The function of the searching unit 112 is provided when the processor 301 accesses the RAM 302 and performs collation determination based on the results of the access. The function of the writing unit 114 is provided when the processor 301 accesses the RAM 302 according to the processing status in the register.

For example, the functional blocks in the decompression unit 12 are executed by using the hardware group 21 as follows. The function of the controlling unit 121 is provided when the processor 301 accesses the RAM 302 (such as securing a storage area and loading a file), manages the processing status (such as the reading position and the writing position) in the register, and performs matching determination on the information held in the register. The function of the reading unit 123 is provided when the processor 301 accesses the RAM 302 according to the processing status in the register. The function of the searching unit 122 is provided, when the processor 301 accesses the RAM 302 and performs collation determination based on the results of the access. The function of the writing unit 124 is provided when the processor 301 accesses the RAM 302 according to the processing status in the register.

For example, the functional blocks in the generation unit 13 are executed by using the hardware group 21 as follows. The function of the controlling unit 131 is provided when the processor 301 manages the area of the RAM 302, accesses the RAM 302, and calls the routine according to the results of the routine processing. The function of the statistical unit 132 is provided when the processor 301 accesses the RAM 302 and performs arithmetic processing based on the results of the access. The function of the sort unit 134 is provided when the processor 301 accesses the RAM 302, and performs arithmetic processing based on the results of the access. The function of the assignment unit 133 is provided when the processor 301 performs arithmetic processing based on the access to the RAM 302.

For example, the functional blocks in the generation unit 14 are executed by using the hardware group 21 as follows. The function of the controlling unit 141 is provided when the processor 301 manages the area of the RAM 302, accesses the RAM 302, and calls the routine according to the results of the routine processing. The function of the copying unit 143 is provided when the processor 301 accesses the RAM 302. The function of the sort unit 144 is provided when the processor 301 accesses the RAM 302, and performs arithmetic processing based on the results of the access. The function of the assignment unit 142 is provided when the processor 301 performs arithmetic processing based on the access to the RAM 302.

FIG. 30 is a configuration example of a system using the computer 1. The information processing system illustrated in FIG. 30 includes a base station 2, the network 3, a computer 1a, and a computer 1b. The computer 1a is connected to the network 3, which is connected to the computer 1b, by at least one of wired and wireless manners. Only the computer 1a may include the compression unit 11, the decompression unit 12, the generation unit 13, and the generation unit 14 illustrated in FIG. 3. Alternatively, both the computer 1a and the computer 1b may include the compression unit 11, the decompression unit 12, the generation unit 13, and the generation unit 14 illustrated in FIG. 3. The computer 1a may include the compression unit 11 and the generation unit 13, and the computer 1b may include the decompression unit 12 and the generation unit 14. Conversely, the computer 1b may include the compression unit 11 and the generation unit 13, and the computer 1a may include the decompression unit 12 and the generation unit 14.

For example, the compressed file F2 generated in the computer 1a is transmitted to the computer 1b through communication via the network 3. The decompressed file F3 is generated when the computer 1b decompresses the compressed file F2. The compressed file F2 may be transmitted to the base station 2 wirelessly, and transmitted to the computer 1b from the base station 2.

The compression function and the decompression function according to the present embodiment prevent an increase in the compression ratio. Accordingly, the amount of compressed data to be transmitted is reduced. As a result, the usage of the hardware resource in the system illustrated in FIG. 30 relative to the communication process is reduced.

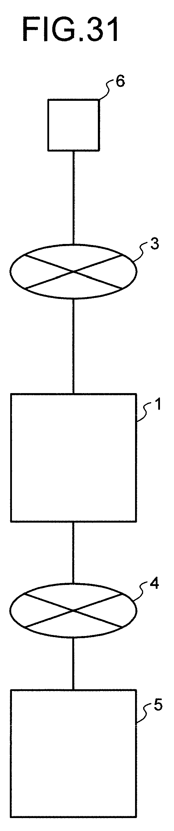

FIG. 31 is a configuration example of a system using the computer 1. The information processing system illustrated in FIG. 31 includes the computer 1, the network 3, a client device 6, the SAN 4, and a storage device 5. For example, the computer 1 performs information processing according to the request from the client device 6. The data whose information is to be processed, for example, is compressed and stored in the storage device 5. On receiving a request from the client device 6, the computer 1 obtains the data whose information is to be processed, which is compressed and stored in the storage device 5, and decompresses it. The computer 1 executes the information processing requested from the client device 6 on the decompressed data, compresses the data on which information processing has been performed, and stores it in the storage device 5. The information processing, for example, includes update of data stored in the storage device 5 and analysis of data stored in the storage device 5.

In the system illustrated in FIG. 31, the compression processing or the decompression dictionary may be executed by retaining a compression dictionary and a decompression dictionary once created, and executing the processing based on the compression dictionary and the decompression dictionary, instead of generating a compression dictionary and a decompression dictionary every time the compression processing and decompression processing are performed. In this case, the processing at S103 in FIG. 4 and the processing at S503 in FIG. 11 may be performed, by simply loading the compression dictionary and the decompression dictionary being retained.

In the system illustrated in FIG. 31, the data is decompressed every time the request of information processing is received. When the decompression processing takes time, the time to respond to the request is also increased. Because the compression function according to the present embodiment prevents a reduction in the compression ratio, it also prevents an increase in the input/output (I/O) rate of compressed data to and from the storage device 5. Because the number of compressed codes does not increase significantly, the number of times of memory access during decompression is also prevented from increasing. The storage area to be secured for loading the compressed file F2 is also reduced.

### [Types of Compression Codes]

About 4,000 English words that are included in English-Japanese dictionaries and the like are classified as English words that students need to learn until he/she finishes University's general education courses. These 4,000 words are basic English words that are used relatively frequently in document data. Among these 4,000 words, about 2,000 words are nouns, about 700 words are adjectives, and about 800 words are verbs. For example, if a compressed code is assigned to each inflected form of the adjectives, about 2,100 types of compressed codes are assigned to the adjectives. If a compressed code is assigned to each inflected form of the verbs, about 3,200 to 4,000 types of compressed codes are assigned to the verbs (some verbs have the same past tense and past participle. Accordingly, each verb has four or five types of inflected forms).

The general Huffman coding algorithm may be used to generate a compression dictionary and a decompression dictionary of the present embodiment, instead of the configurations of the compression dictionary and the decompression dictionary illustrated in the present embodiment. In the decompression dictionary that uses Huffman coding, bits are assigned by comparing the appearance frequencies of the pieces of character information to which compressed codes are assigned. Here, data of a node is generated. The node corresponds to a set of pieces of character information whose appearance frequencies are compared. Furthermore, bits are generated sequentially, by comparing the appearance frequencies of the generated nodes. By repeating the above-described procedures, tree-structured data (Huffman tree) is formed. If there are 2 to the 12th power pieces of character information (leaf data) to which compressed codes are assigned, data of nodes are generated for 2 to the 11th power, by comparing them. When the data of nodes are sequentially generated, by comparing the frequency information of the nodes, the total of the data of leaves and the data of nodes are 2 to the 13th power. The data of nodes includes a pointer to the data of upper node and a pointer to the data of lower node (both when the bit is 1 and when the bit is 0). When each pointer is 2 bytes in size, the pointer can specify the position in the Huffman tree data structure of 3 times 2 to the 14th power.

However, if the compressed codes are assigned to inflected forms, 4,000 basic words will increase to around 8,000 words. This means, there are 2 to the 13th power pieces of character information to which compressed codes are assigned. As a result, it is not possible to specify the position in the Huffman tree data structure by the 2 bytes. Then, depending on the architecture, for example, the pointers use 4 bytes. Because the objects to which the compressed codes are assigned are doubled, the data size of the Huffman tree is also doubled, and because of the data size of the pointers, it further doubles.

### [Explanation of Modification]

A part of a modification according to the present embodiment described above will now be explained. Synonyms and near-synonyms may be set in the conversion table T1 illustrated in FIG. 7. For example, pieces of character information "center", "centre", and "middle" are mapped to the common character information "center". Furthermore, in the conversion table T1, for example, the character information "center" is mapped to the combination of the common character information "center" and the identifying symbol [c1]. In the conversion table T1, for example, the character information "centre" is mapped to the combination of the common character information "center" and the identifying symbol [c2]. In the conversion table T1, for example, the character information "middle" is mapped to the combination of the common character information "center" and the identifying symbol [c3]. When the conversion table T1, in which the synonyms and near-synonyms are set in this manner, is applied to the above-described embodiment, it is possible to prevent a reduction in the compression ratio, due to orthographic variants such as synonyms and near-synonyms.

Both the words whose first letter is a capital letter and the words whose first letter is a small letter may be set in the conversion table T1 illustrated in FIG. 7. In the conversion table T1, for example, pieces of character information "this" and "This" are both mapped to the common character information "this". The character information "this" is mapped to the combination of the common character information "this" and the identifying symbol [c1]. The character information "This" is mapped to the combination of the common character information "this" and the identifying symbol [c2]. When the conversion table T1, in which both of the words whose first letter is the capital letter and the small letter are set in this manner, is applied to the embodiment described above, it is possible to prevent a reduction in the compression ratio, due to orthographic variants caused by the word at the beginning of a sentence.

The object to be compressed may be a monitor message output from a system, instead of a file. For example, a monitor message sequentially stored in the buffer may be compressed by the compression processing described above, and is processed by storing it as a log file or the like. For example, the compression may be performed in a unit of a page in the database, or the compression may be performed in a unit of a plurality of pages. The common compression dictionary may be used for the monitor messages, and the common compression dictionary may be used for the multiple pages.

### [Explanation of Reference]

- 1: Computer
- 1a: Computer
- 1b: Computer
- 2: Base station
- 3: Network
- 4: Storage area network
- 5: Storage device
- 6: Client device
- 11: Compression unit
- 12: Decompression unit
- 13: Generation unit
- 14: Generation unit
- 15: Storage unit

## Claims

1. A compression device comprising:
a storage unit configured to store therein dictionary information in which a first compressed code assigned to a plurality of pieces of character information different from one another is associated with the pieces of character information;
an acquiring unit configured to, when a first piece of character information among the pieces of character information is acquired, acquire the first compressed code associated with the first piece of character information from the dictionary information; and
a writing unit configured to write the acquired first compressed code in a storage area to store compressed data.

2. The compression device according to claim 1, wherein
the pieces of character information are mutually common in at least a part of a meaning or a grammatical function expressed by the pieces of character information, and
the first compressed code is generated based on a total of appearance frequencies of the pieces of character information.

3. The compression device according to claim 1 or 2, wherein
the dictionary information further associates the first piece of character information with first identifying information that discriminates character information other than the first piece of character information included in the pieces of character information, from the first piece of character information,
the acquiring unit acquires the first compressed code as well as the first identifying information, and
the writing unit writes the first compressed code and the first identifying information in the storage area.

4. The compression device according to claim 3, wherein
the first identifying information is a compressed code generated based on an appearance frequency of the first piece of character information, and
the first compressed code is written subsequent to the first identifying information in the storage area.

5. The compression device according to claim 3, wherein the first identifying information is a fixed length compressed code and written subsequent to the first compressed code in the storage area.

6. A compression method that causes a computer to execute:
acquiring, by referring to dictionary information in which a first compressed code assigned to a plurality of pieces of character information different from one another is associated with the pieces of character information when a first piece of character information among the pieces of character information is acquired, the first compressed code associated with the first piece of character information in the dictionary information; and
writing the acquired first compressed code in a storage area to store compressed data.

7. A compression program that causes a computer to execute:
acquiring, by referring to dictionary information in which a first compressed code assigned to a plurality of pieces of character information different from one another is associated with the pieces of character information when a first piece of character information among the pieces of character information is acquired, the first compressed code associated with the first piece of character information in the dictionary information; and
writing the acquired first compressed code in a storage area to store compressed data.

8. A decompression device comprising:
a storage unit configured to store therein dictionary information in which a first compressed code assigned in common to a plurality of pieces of character information different from one another is associated with a first piece of character information corresponding to the pieces of character information;
an acquiring unit configured to, when the first compressed code is acquired from compressed data, acquire the first piece of character information associated with the first compressed code in the dictionary information, from the dictionary information; and
a writing unit configured to write the acquired first piece of character information in a storage area to store a decompression result of the compressed data.

9. The decompression device according to claim 8, wherein by associating storage destination information that indicates a storage destination of a combination of the first piece of character information and identifying information that discriminates a second piece of character information included in the pieces of character information from character information other than the second piece of character information included in the pieces of character information, with the first compressed code, the dictionary information associates the first compressed code with the first piece of character information.

10. The decompression device according to claim 9, wherein
the first compressed code is generated based on a total of appearance frequencies of the pieces of character information,
the dictionary information further associates the first compressed code with flag information that indicates that the first compressed code is generated based on the total of the appearance frequencies of the pieces of character information, and
the acquiring unit, when the flag information is associated with the first compressed code in the dictionary information, acquires the first piece of character information by accessing the storage destination based on the storage destination information.

11. A decompression method that causes a computer to execute:
generating dictionary information in which a first compressed code assigned in common to a plurality of pieces of character information different from one another is associated with a first piece of character information corresponding to the pieces of character information;
acquiring, when the first compressed code is acquired from compressed data, the first piece of character information associated with the first compressed code in the dictionary information, from the dictionary information; and
writing the acquired first piece of character information in a storage area to store a decompression result of the compressed data.

12. A decompression program that causes a computer to execute:
generating dictionary information in which a first compressed code assigned in common to a plurality of pieces of character information is associated with a first piece of character information corresponding to the pieces of character information;
acquiring, when the first compressed code is acquired from compressed data, the first piece of character information associated with the first compressed code in the dictionary information, from the dictionary information; and
writing the acquired first piece of character information in a storage area to store a decompression result of the compressed data.

13. An information processing system comprising:
a storage device configured to store therein compressed data; and
a processing device configured to execute processing according to a processing request on the compressed data, the processing device comprising:
a storage unit configured to store therein dictionary information in which a first compressed code assigned to a plurality of pieces of character information different from one another is associated with the pieces of character information;
a reading unit configured to read out the compressed data from the storage device according to the processing request;
a first acquiring unit configured to, when the first compressed code is acquired from the compressed data, acquire first character information associated with the first compressed code in the dictionary information, from the dictionary information;
a first writing unit configured to write the acquired first character information in a first storage area to store a decompression result of the compressed data;
a processing unit configured to execute the processing according to the processing request on the decompression result stored in the first storage area;
a second acquiring unit configured to, when the first character information is acquired from data on which the processing according to the processing request is performed, acquire the first compressed code associated with the first character information in the dictionary information;
a second writing unit configured to write the acquired first compressed code in a second storage area; and
a storage unit configured to store, in the storage device, data written in the second area.

14. A dictionary generation device comprising:
an assignment unit configured to assign a compressed code to one type of common character information corresponding to a plurality of pieces of character information different from one another; and
a generation unit configured to generate dictionary information in which a first compressed code assigned to the common character information is associated with the individual pieces of character information.

15. The dictionary generation device according to claim 14, wherein
the pieces of character information are mutually common in at least a part of a meaning or a grammatical function expressed by the pieces of character information, and
the compressed code is generated based on a total of appearance frequencies of the pieces of character information.

16. The dictionary generation device according to claim 14 or 15, wherein the dictionary information further associates a first piece of character information among the pieces of character information with first identifying information that discriminates character information other than the first piece of character information included in the pieces of character information, from the first piece of character information.

17. A dictionary generation method that causes a computer to execute:
assigning a compressed code to one type of common character information corresponding to a plurality of pieces of character information different from one another; and
generating dictionary information in which a first compressed code assigned to the common character information is associated with the individual pieces of character information.

18. A dictionary generation program that causes a computer to execute:
assigning a compressed code to one type of common character information corresponding to a plurality of pieces of character information different from one another; and
generating dictionary information in which a first compressed code assigned to the common character information is associated with the individual pieces of character information.

19. A dictionary generation device comprising:
a generation unit configured to generate dictionary information in which a first compressed code assigned in common to a plurality of pieces of character information different from one another is associated with a first piece of character information corresponding to the pieces of character information.

20. A dictionary generation method that causes a computer to execute:
generating dictionary information in which a first compressed code assigned in common to a plurality of pieces of character information different from one another is associated with a first piece of character information corresponding to the pieces of character information.

21. A dictionary generation program that causes a computer to execute:
generating dictionary information in which a first compressed code assigned in common to a plurality of pieces of character information different from one another is associated with a first piece of character information corresponding to the pieces of character information.
